# EUROPEAN PATENT SPECIFICATION

(11) **EP 2 268 120 B1**
(45) Date of publication and mention of the grant of the patent: **14.06.2017**
(21) Application number: 10006492.2
(22) Date of filing: 22.06.2010
(51) Int. Cl.: H05K 13/08, G05B 19/418

(54) **Component mounting line design device, program, and component mounting system**
Vorrichtung zum Konzipieren einer Komponentenmontagestraße, Programm und Komponentenmontagesystem
Dispositif de design de ligne d'assemblage de composant, programme et système d'assemblage de composant

(30) Priority: 26.06.2009 JP 2009152451
(43) Date of publication of application: 29.12.2010
(73) Proprietor: Yamaha Hatsudoki Kabushiki Kaisha, Iwata-shi, Shizuoka 438-8501 (JP)
(72) Inventor: Chida, Takafumi, Chiyoda-ku Tokyo 100-8220 (JP); Tsujimoto, Yoshiyuki, Chiyoda-ku Tokyo 100-8220 (JP); Izuhara, Koichi, Chiyoda-ku Tokyo 100-8220 (JP); Moriya, Yuji, Chiyoda-ku Tokyo 100-8220 (JP)
(74) Representative: Müller-Boré & Partner Patentanwälte PartG mbB

(56) References cited:
- EP-A1- 1 777 648
- EP-A2- 0 435 451
- DE-A1- 10 230 356
- TANG C S ET AL: "MODELS ARISING FROM A FLEXIBLE MANUFACTURING MACHINE, PART I: MINIMIZATION OF THE NUMBER OF TOOL SWITCHES", OPERATIONS RESEARCH, BALTIMORE, MD, US, vol. 36, no. 5, 1 September 1988 (1988-09-01), pages 767-777, XP000747619,

## Description

### BACKGROUND OF THE INVENTION

### 1. Field of the Invention

The present invention relates to techniques for identifying a component mounting line in producing a plurality of types of boards.

### 2. Related Art

In the printed circuit board production, with a reduction in the size of a component mounting device or with the unitization of the configuration, etc., a change work of the configuration of a component mounting line, such as the movement of a component mounting device or the replacement of a mounting head for mounting a component, has been facilitated. As such, an effort to increase the production efficiency has been made by changing the configuration of a component mounting line according to the type of a printed circuit board to produce and producing printed circuit boards.

For example, JP-A-2009-49440 discloses a technique, wherein for a printed circuit board production plan which a user inputs, a configuration of a component mounting line satisfying a target cycle time which the user inputs and additionally reducing the number of devices as few as possible or a configuration of a component mounting line providing the cycle time as short as possible under a limited resource (the number of devices, or the like) is calculating for each type of a printed circuit board to produce.
EP 0 435 451 A2 relates to a method of sequencing jobs in a flexible manufacturing environment.
EP 1 777 648 A1 relates to production planning with sequence independent setup activities.
DE 102 30 356 A1 relates to an apparatus and method for production simulation which simulates to calculate a total number of assembly boards manufactured with time by an electronic-component-mounting apparatus which includes a component feeding section having plural component feeders for feeding various components.
TANG C S ET AL: "MODELS ARISING FROM A FLEXIBLE MANUFACTURING MACHINE, PART I: MINIMIZATION OF THE NUMBER OF TOOL SWITCHES", OPERATIONS RESEARCH, BALTIMORE, MD, US, vol. 36, no. 5, 1 September 1988 (1988-09-01), pages 767-777, XP000747619, relates to considering a job scheduling problem for a flexible manufacturing machine.

### SUMMARY OF THE INVENTION

In the technique according to JP-A-2009-49440 , in each one type of printed circuit board, such a mounting line configuration that reduces the cycle time as short as possible can be calculated. However, the amount of change work in changing the type of a printed circuit board to produce is not fully taken into consideration, and if this change work takes a long time, the cycle time as a whole in producing a plurality of types of printed circuit boards also increases.

Then, it is an object of the present invention to calculate such a change plan of a component mounting line that minimizes the amount of change work of a component mounting line in producing a plurality of boards.

In order to solve the above problem, according to an aspect of the present invention, the change amount in a component mounting line when a board type is changed from a component mounting line for each board type is calculated, so that boards are produced in an order from the board type wherein the calculated change amount is smaller.

A component mounting line design device according to the present invention is defined in claim 1.

As described above, according to the present invention, it is possible to calculate such a change plan of a component mounting line which reduces the amount of change work of the component mounting line as small as possible in producing a plurality of boards.

### BRIEF DESCRIPTION OF THE DRAWINGS

Fig. 1 is a schematic diagram of a component mounting system.
Fig. 2 is a schematic diagram of a component mounting line design device.
Fig. 3 is a schematic diagram of a production plan information table.
Fig. 4 is a schematic diagram of a design parameter information table.
Fig. 5 is a schematic diagram of a component mounting line information table.
Fig. 6 is a schematic diagram of a component mounting information table.
Fig. 7 is a schematic diagram of a board information table.
Fig. 8 is a schematic diagram of a mounting component information table.
Fig. 9 is a schematic diagram of a resource information table.
Fig. 10 is a schematic diagram of a device information table.
Fig. 11 is a schematic diagram of a computer.
Fig. 12 is a schematic diagram of a component mounting device.
Fig. 13 is a schematic diagram of a component mounting section, a cart, and a tray.
Fig. 14 is a schematic diagram of an information storage device.
Fig. 15 is a PAD showing an example of a component mounting line design procedure in the component mounting line design device.
Fig. 16 is a schematic diagram of a component mounting line design condition input screen.
Fig. 17 is a PAD showing an example of producing a board group.
Fig. 18 is a PAD showing an example of calculating an amount of change work of a line configuration between board groups.
Fig. 19 is a PAD showing an example of calculating a production sequence of a board group.
Fig. 20 is a schematic diagram of a screen of a component mounting line design result.
Fig. 21 is a PAD showing an example of a processing during board production in the component mounting system.
Fig. 22 is a schematic diagram of a display screen of a board production instruction.
Fig. 23 is a schematic diagram of a display screen of a component arrangement result.

### DETAILED DESCRIPTION OF THE INVENTION

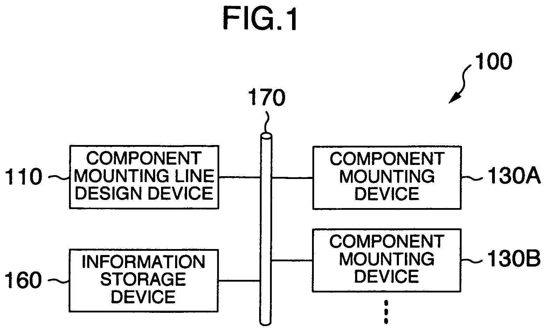

Fig. 1 is a schematic diagram of a component mounting system 100 which is one embodiment of the present invention. As shown in the view, the component mounting system 100 includes a component mounting line design device 110, component mounting devices 130A and 130B (hereinafter, referred to as a component mounting device 130 when these component mounting devices do not particularly need to be distinguished from each other), and an information storage device 160. Here, these devices are adapted to be able to transmit/receive information via a network 170.

Here, in the component mounting system 100, the component mounting line design device 110 calculates a configuration of a component mounting line (the number of component mounting devices 130, a mounting head, a component feeder device, and an arrangement thereof) which meets an input condition from a user, and presents this configuration to the user. The user changes the mounting head and the component feeder device of the component mounting device 130, arranges the component mounting device 130 and builds a component mounting line according to the configuration of a component mounting line presented by the component mounting line design device 110, thereby enabling production of boards.

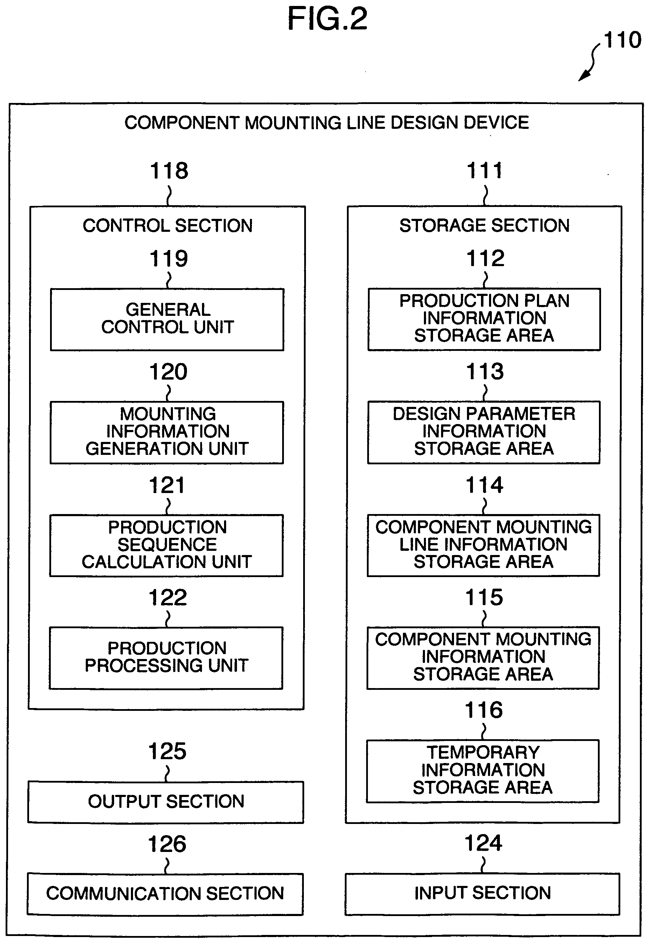

Fig. 2 is a schematic diagram of the component mounting line design device 110. As shown in the view, the component mounting line design device 110 includes a storage section 111, a control section 118, an input section 124, an output section 125, and a communication section 126.

The storage section 111 includes a production plan information storage area 112, a design parameter information storage area 113, a component mounting line information storage area 114, a component mounting information storage area 115, and a temporary information storage area 116.

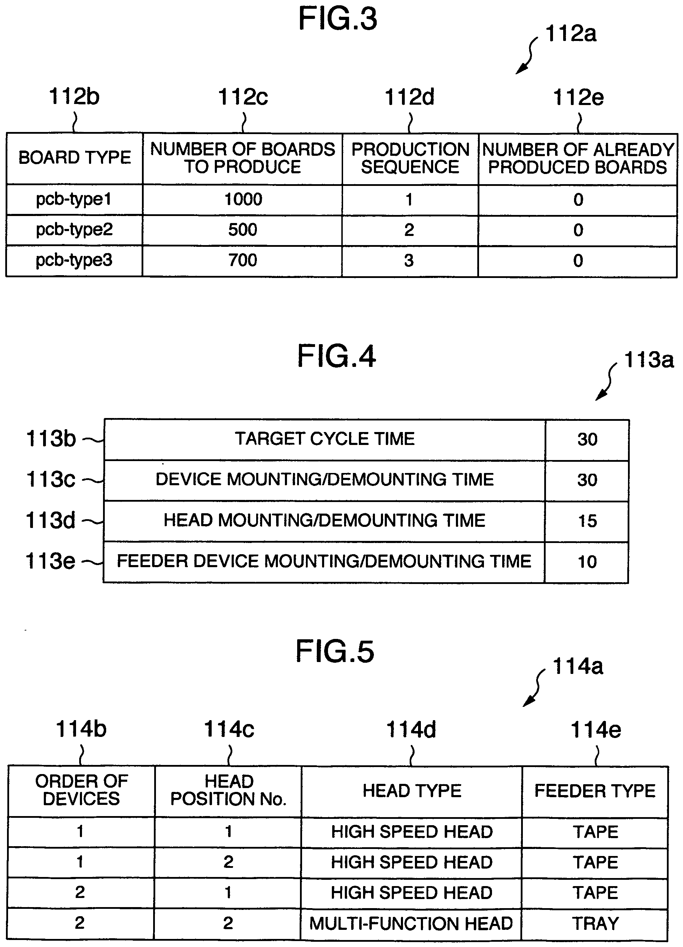

Production plan information for identifying the type of a board to produce using the component mounting device 130, the number of boards, and a production sequence is stored in the production plan information storage area 112. For example, a production plan information table 112a as shown in Fig. 3 (a schematic diagram of the production plan information table 112a) is stored.

As shown in the view, the production plan information table 112a includes a board type column 112b, a "number of boards to produce" column 112c, a production sequence column 112d, and a "number of already produced boards" column 112e.

Information for identifying the type of a board to produce is stored in the board type column 112b.

Information for identifying the number of boards to produce of a type identified by the board type column 112b is stored in the "number of boards to produce" column 112c.

Information for identifying the production sequence of boards of a type identified by the board type column 112b is stored in the production sequence column 112d.

Information for identifying the number of already produced boards of a type identified by the board type column 112b is stored in the "number of already produced boards" column 112e.

Returning to Fig. 2, design parameter information for identifying a design parameter in configuring a component mounting line is stored in the design parameter information storage area 113. For example, a design parameter information table 113a as shown in Fig. 4 (a schematic diagram of the design parameter information table 113a) is stored.

As shown in the view, the design parameter information table 113a includes a target cycle time row 113b, a device mounting/demounting time row 113c, a head mounting/demounting time row 113d, and a feeder device mounting/demounting time row 113e.

Information for identifying a target value (maximum value) of the cycle time in producing each board is stored in the target cycle time row 113b.

Information for identifying a processing time in attaching or detaching the component mounting device 130 to a component mounting line is stored in the device mounting/demounting time row 113c.

Information for identifying a processing time in attaching or detaching a mounting head of the component mounting device 130 is stored in the head mounting/demounting time row 113d.

Information for identifying a processing time in attaching or detaching the component feeder device of the component mounting device 130 is stored in the feeder device mounting/demounting time row 113e.

Returning to Fig. 2, component mounting line information for identifying an order of arranging the component mounting device 130, a type of a mounting head to attach, and a component feeder type (method) is stored in the component mounting line information storage area 114. For example, a component mounting line information table 114a as shown in Fig. 5 (a schematic diagram of the component mounting line information table 114a) is stored.

As shown in the view, information for identifying an "order of devices" column 114b, a head position No. column 114c, and a head type column 114d, and a feeder type column 114e is stored in the component mounting line information table 114a.

Information for identifying an order of arranging the component mounting device 130 (a position where the component mounting device 130 is arranged) in a component mounting line is stored in the "order of devices" column 114b.

Information for identifying a position at which a mounting head of the component mounting device 130 arranged in an order identified by the "order of devices" column 114b is attached is stored in the head position No. column 114c. Here, in this embodiment, a number preliminarily assigned to a position at which the mounting head can be attached, of the component mounting device 130 is stored as the information for identifying a position where a mounting head is attached.

Information for identifying the type of a mounting head of the component mounting device 130 which is arranged in an order identified by the device order column 114b, the mounting head being attached at a position identified by the head position No. column 114c, is stored in the head type column 114d.

Information for identifying a feeder type (feeder method) of a component feeder unit of the component mounting device 130 which is arranged in an order identified by the device order column 114b is stored in the feeder type column 114e.

Returning to Fig. 2, component mounting information including: information for identifying a position at which the component feeder unit is attached; and information for identifying a position at which a component is mounted, a mounting head sucking a component from a component feeder unit, and a sucking/mounting sequence is stored in the component mounting information storage area 115.

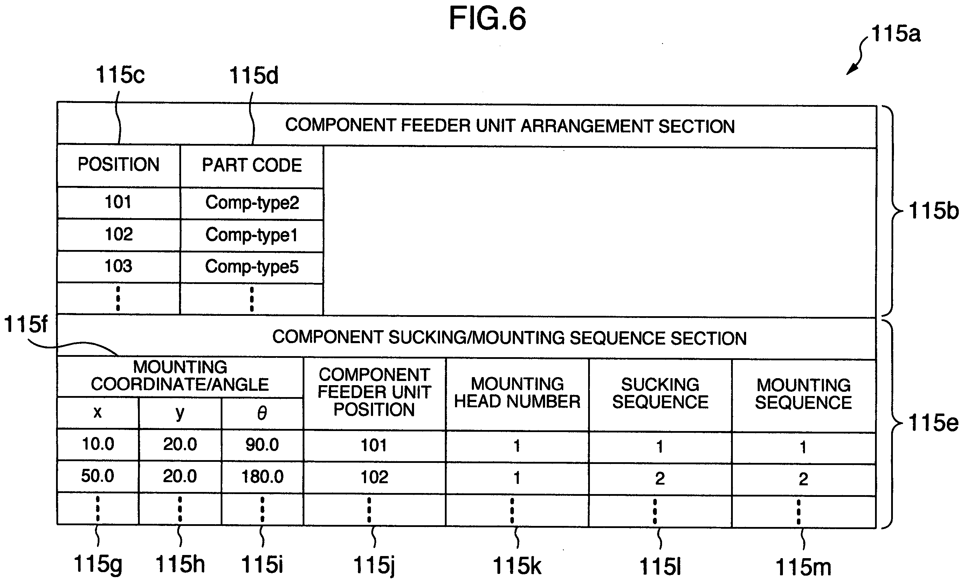

For example, in this embodiment, a component mounting information table 115a as shown in Fig. 6 (a schematic diagram of the component mounting information table 115a) is stored.

As shown in the view, the component mounting information table 115a includes a component feeder unit arrangement section 115b and a component sucking/mounting sequence section 115e.

Information for identifying a position at which a component feeder unit is mounted is stored in the component feeder unit arrangement section 115b. For example, the component feeder unit arrangement section 115b includes a position column 115c and a part code column 115d.

Information for identifying a position, at which a component feeder unit for mounting a component identified by the part code column 115d described later is attached, is stored in the position column 115c. For example, in this embodiment, predetermined identification information (e.g., a position number sequentially numbered from one end of a cart, a position number assigned to each stage of a multi-stage tray) is assigned to a position of a cart at which a component feeder unit is attached and a position of a multi-stage tray at which a component feeder unit is attached. Then, this identification information is stored for each component.

Information for identifying the type of a component mounted on a board is stored in the part code column 115d. Here, in this embodiment, as the information for identifying the type of a component, a part code is stored.

The component sucking/mounting sequence section 115e includes a mounting coordinate/angle column 115f, a component feeder unit position column 115j, a mounting head number column 115k, a sucking order column 1151, and a mounting order column 115m.

Information for identifying the position and angle on a board, where a component is mounted on a component feeder unit arranged at a position identified by the component feeder unit position column 115j described later, is stored in the mounting coordinate/angle column 115f.

For example, in this embodiment, the mounting coordinate/angle column 115f includes an x column 115g, a y column 115h, and a θ column 115i, wherein pieces of information for identifying a value of the x-coordinate, a value of the y-coordinate, and an angle at which a component is mounted in a board for mounting a component are stored in the respective columns.

Information for identifying the position of a component feeder unit for mounting a component, which is attached at the position and angle of a board identified by the mounting coordinate/angle column 115f, is stored in the component feeder unit position column 115j. Here, in this embodiment, a value corresponding to the position column 115c in the component feeder unit arrangement section 115b is stored.

Information for identifying a mounting position in the component mounting device 130 of a mounting head to suck a component, which a component feeder unit stacked at a position identified by the component feeder unit position column 115j mounts, is stored in the mounting head number column 115k.

Information for identifying an order for a mounting head to suck a component, which a component feeder unit stacked at a position identified by the component feeder unit position column 115j mounts, is stored in the sucking order column 1151.

Information for identifying an order for a mounting head to mount a component, which a component feeder unit stacked at a position identified by the component feeder unit position column 115j mounts, on a board is stored in the mounting order column 115m.

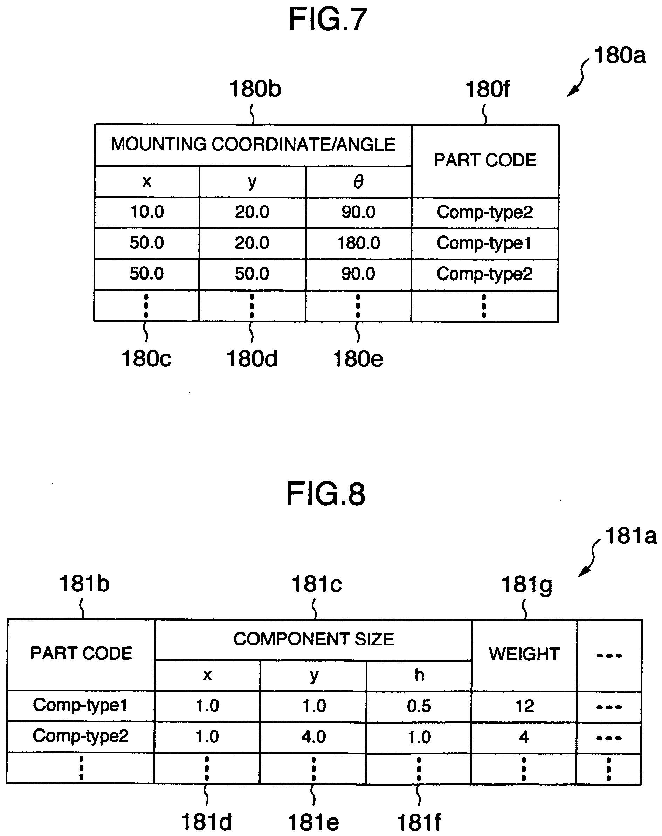

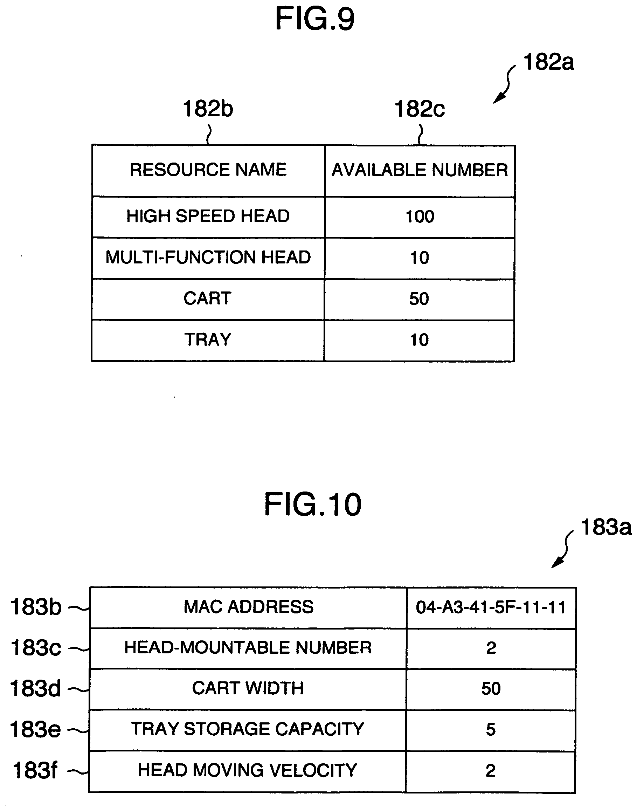

Information required for the processing in the component mounting line design device 110 is stored in the temporary information storage area 116. For example, in this embodiment, a board information table 180a as shown in Fig. 7 (a schematic diagram of the board information table 180a), a mounting component information table 181a as shown in Fig. 8 (a schematic diagram of the mounting component information table 181a), a resource information table 182a as shown in Fig. 9 (a schematic diagram of the resource information table 182a), and a device information table 183a as shown in Fig. 10 (a schematic diagram of the device information table 183a) are stored in the temporary information storage area 116.

As shown in Fig. 7, the board information table 180a includes a mounting coordinate/angle column 180b and a part code column 180f.

Information for identifying a position and angle on a board for mounting a component of a type identified by the part code column 181b described later is stored in the mounting coordinate/angle column 180b.

For example, in this embodiment, the mounting coordinate/angle column 180b includes an x column 180c, a y column 180d, and a θ column 180e, wherein pieces of information for identifying a value of the x-coordinate, a value of the y-coordinate, and an angle at which a component is mounted in a board for mounting a component are stored in the respective columns.

Information for identifying the type of a component attached at a position and angle on a board identified by the mounting coordinate/angle column 180b is stored in the part code column 180f. Here, in this embodiment, as the information for identifying the type of a component, a part code is stored.

As shown in Fig. 8, the mounting component information table 181a includes a part code column 181b, a component size column 181c, and a weight column 181g.

Information for identifying the type of a component is stored in the part code column 181b. Here, in this embodiment, as the information for identifying the type of a component, a part code is stored.

Information for identifying the size of a component of a type identified by the part code column 181b is stored in the component size column 181c.

For example, in this embodiment, the component size column 181c includes an x column 181d, a y column 181e, and an h column 181f, wherein pieces of information for identifying the width, the depth, and the height of a component identified by the part code column 181b are stored in these columns, respectively.

Information for identifying the weight of a component identified by the part code column 181b is stored in the weight column 181g.

As shown in Fig. 9, the resource information table 182a includes a resource name column 182b and an available number column 182c.

Information for identifying a resource in mounting a component in the component mounting system 100 is stored in the resource name column 182b.

Information for identifying the available number (the maximum available number) of a resource identified by the resource name column 182b is stored in the available number column 182c.

As shown in Fig. 10, the device information table 183a includes a MAC address row 183b, a "mountable number of head" row 183c, a cart width row 183d, a tray storage capacity row 183e, and a head moving velocity row 183f.

Information for identifying a communication address of the component mounting device 130 is stored in the MAC address row 183b. In this embodiment, as the information for identifying the communication address of the component mounting device 130, a MAC address is stored.

Information for identifying the number of mounting heads which can be mounted on the component mounting device 130 is stored in the "mountable number of head" row 183c.

Information for identifying the cart width (the number of component mounting units which can be mounted on the cart) of a cart of the component mounting device 130 is stored in the cart width row 183d.

Information for identifying the number of trays which can be mounted on the multi-stage tray of the component mounting device 130 is stored in the tray storage capacity row 183e.

Information for identifying the moving velocity of a mounting head mounted on the component mounting device 130 is stored in the head moving velocity row 183f.

Returning to Fig. 2, the control section 118 includes a general control unit 119, a mounting information generation unit 120, a production sequence calculation unit 121, and a production processing unit 122.

The general control unit 119 controls the whole processing in the component mounting line design device 110.

The mounting information generation unit 120 collects from each component mounting device 130 the configuration data for identifying an order, in which the component mounting device 130 is arranged, the type of a head mounted at a mounting position of a mounting head, and a component feeder method, and generates from the collected configuration data the component mounting line information table 114a as shown in Fig. 5, and further associates the configuration data with information for identifying a current line configuration and the board type produced in the current line configuration, and stores these associated data and information in the component mounting line information storage area 114.

Moreover, the mounting information generation unit 120 receives an input of production schedule data including the type of a board to produce and the number thereof as well as design parameters including a target cycle time, a device mounting/demounting time, a head mounting/demounting time, and a feeder device mounting/demounting time, and generates, for each board type, the component mounting line information and component mounting information satisfying the above-described input data and parameters, and further associates these pieces of information with a board type and stores the associated information into the component mounting line information area 114 and the component mounting information storage area 115 as the component mounting line information table 114a and the component mounting information table 115a.

The production sequence calculation unit 121 calculates a board production sequence providing a shorter change work time of a component mounting line, from the component mounting line information for each board type contained in the component mounting line information and production plan of the current line stored in the component mounting line information storage area 114.

The production processing unit 122 outputs component mounting line information to the output section 125 so that the boards may be produced in the board production sequence calculated by the production sequence calculation unit 121, and also outputs the component mounting information and mounting component information to the component mounting device 130 via the communication section 126.

The input section 124 receives an input of information.

The output section 125 outputs information.

The communication section 126 transmits and receives information via the network 170.

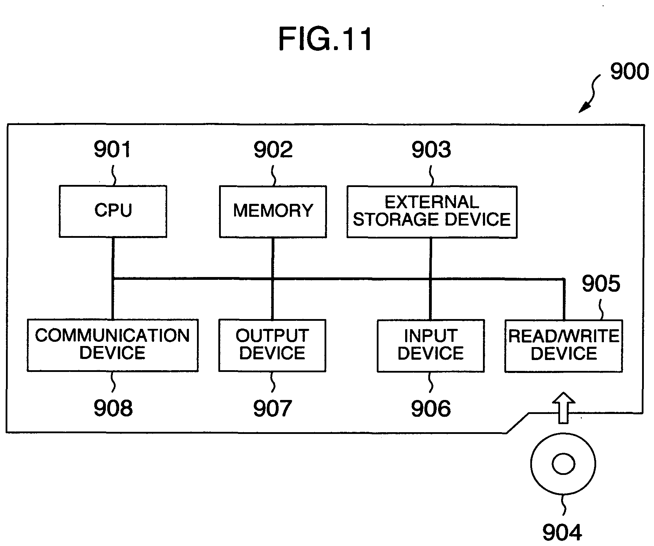

The component mounting line design device 110 described above can be implemented with an ordinary computer 900 including: for example, a CPU (Central Processing Unit) 901 as shown in Fig. 11 (a schematic diagram of the computer 900); a memory 902; an external storage device 903 such as an HDD (Hard Disk Drive); a read/write device 905 which reads/writes information from/to a portable storage medium 904, such as a CD (Compact Disk) or a DVD (Digital Versatile Disk); an input device 906, such as a keyboard or a mouse; an output device 907, such as a display; and a communication device 908, such as a NIC (Network Interface Card) for connecting to a communication network.

For example, the storage section 110 can be implemented by the CPU 901 using the memory 902 or the external storage device 903, the control section 118 can be implemented by loading a predetermined program, which is stored in the external storage device 903, into the memory 902 and causing the CPU 901 to execute this program, the input section 124 can be implemented by the CPU 901 using the input device 906, the output section 125 can be implemented by the CPU 901 using the output device 907, and the communication section 126 can be implemented by the CPU 901 using the communication device 908.

This predetermined program may be downloaded onto the external storage device 903 from the storage medium 904 via the read/write device 905 or from a network via the communication device 908, and then be loaded onto the memory 902 so as to be executed by the CPU 901. Moreover, this predetermined program may be loaded directly onto the memory 902 from the storage medium 904 via the read/write device 905 or from a network via the communication device 908, and then be executed by the CPU 901.

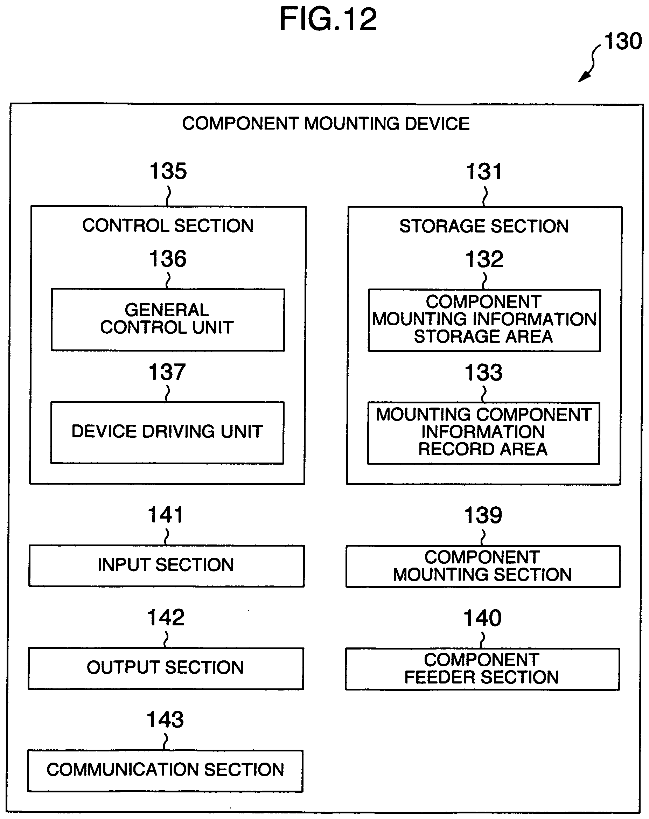

Fig. 12 is a schematic diagram of the component mounting device 130. As shown in the view, the component mounting device 130 includes a storage section 131, a control section 135, a component mounting section 139, a component feeder section 140, an input section 141, an output section 142, and a communication section 143.

The storage section 131 includes a component mounting information storage area 132 and a mounting component information storage area 133.

Component mounting information received from the component mounting line design device 110 is stored in the component mounting information storage area 132. For example, in this embodiment, the component mounting information table 115a as shown in Fig. 6 is stored.

In the mounting component information storage area 133, the mounting component information received from the component mounting line design device 110 is stored. For example, in this embodiment, the mounting component information table 181a as shown in Fig. 8 is stored.

The control section 135 includes a general control unit 136 and a device driving unit 137.

The general control unit 136 controls the whole processing in the component mounting device 130. The general control unit 136 in this embodiment generates, in response to an instruction from the component mounting line design device 110, the configuration data for identifying the order in which the component mounting device 130 is arranged, the type of a head mounted at a mounting position of a mounting head, and the feeder type of a component, and returns this configuration data to the component mounting line design device 110 via the communication section 143.

The device driving unit 137 mounts a component onto a board by controlling the component mounting section 139 and the component feeder section 140.

The component mounting section 139 includes a mounting head, an XY robot to move the mounting head, and a circuit board mounting table for placing a circuit board thereon.

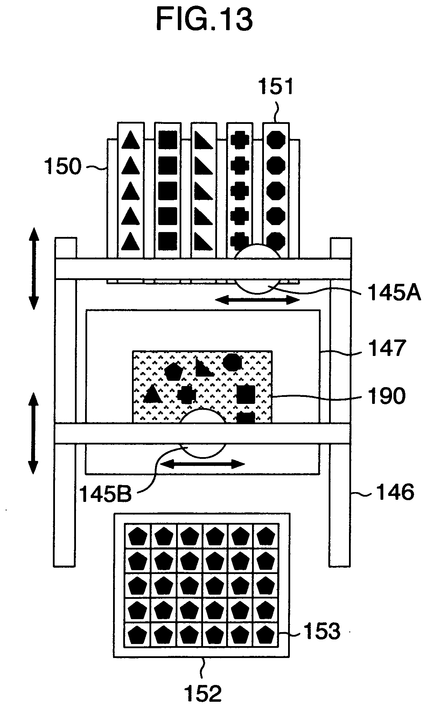

Here, in this embodiment, as shown in Fig. 13 (a schematic diagram of a component mounting section 139, a cart 150, and a multi-stage tray 152), a plurality of mounting heads 145A and 145B suck a component from the cart 150 or a multi-stage tray 152 and mount the sucked component onto a board 190 placed on the circuit board mounting table 147, respectively.

Moreover, the XY robot 146 moves the mounting heads 145A and 145B in an X direction which is one direction with respect to the board 190 and in a Y direction which is the direction crossing the X direction.

The component feeder section 140 is attached with at least either one of the cart 150 and the multi-stage tray 152, thereby feeding a component.

Here, as shown in Fig. 13, the cart 150 has a tape-type component feeder unit 151 stacked thereon, and controls the stacked tape-type component feeder unit 151 to arrange the components, which are mounted on the tape-type component feeder unit 151, at a suction position of the mounting heads 145A and 145B.

Moreover, as shown in Fig. 13, the multi-stage tray has a tray-type component feeder unit 153 stacked thereon, and controls the stacked tray-type component feeder unit 153 to arrange the components, which are mounted on the tray-type component feeder unit 153, at a suction position of the mounting heads 145A and 145B.

The input section 141 receives an input of information.

The output section 142 outputs information.

The communication section 143 transmits and receives information via the network 170.

The component mounting device 130 described above can be implemented, for example, by the computer 900 as shown in Fig. 11 including: a component mounting device (not shown) with a mounting head, an XY robot, and a circuit board mounting table; a cart device (not shown); and a tray device (not shown).

For example, the storage section 131 can be implemented by the CPU 901 using the memory 902 or the external storage device 903, the control section 135 can be implemented by loading a predetermined program, which is stored in the external storage device 903, into the memory 902 and causing the CPU 901 to execute this program, the component mounting section 139 can be implemented by the CPU 901 using a non-illustrated component mounting device, the component feeder section 140 can be implemented by the CPU 901 using a non-illustrated cart device or tray device, the input section 141 can be implemented by the CPU 901 using the input device 906, the output section 142 can be implemented by the CPU 901 using the output device 907, and the communication section 143 can be implemented by the CPU 901 using the communication device 908.

This predetermined program may be downloaded onto the external storage device 903 from the storage medium 904 via the read/write device 905 or from a network via the communication device 908, and then be loaded onto the memory 902 so as to be executed by the CPU 901. Moreover, this predetermined program may be loaded directly onto the memory 902 from the storage medium 904 via the read/write device 905 or from a network via the communication device 908 so as to be executed by the CPU 901.

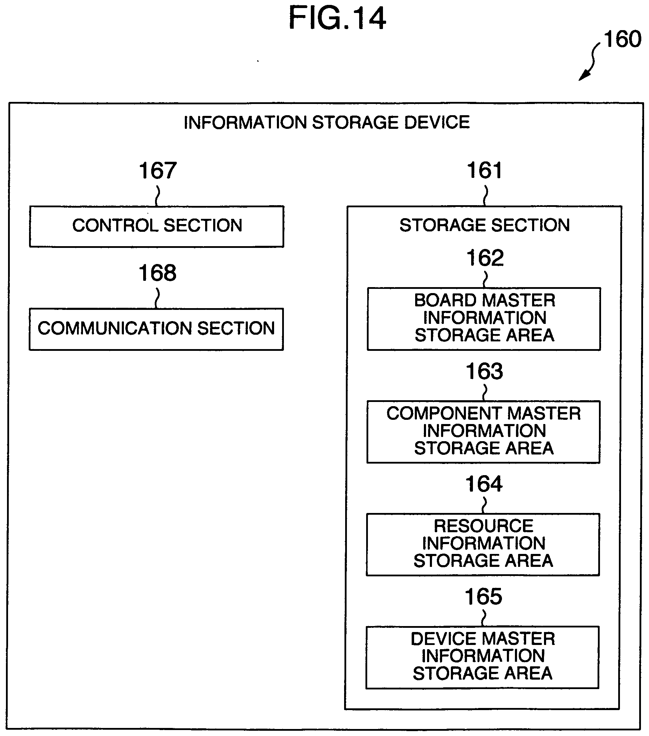

Fig. 14 is a schematic diagram of the information storage device 160.

As shown in the view, the information storage device 160 includes a storage section 161, a control section 167, and a communication section 168.

The storage section 161 includes a board master information storage area 162, a component master information storage area 163, a resource information storage area 164, and a device master information storage area 165.

Substrate master information for identifying the component to be mounted onto a board by the component mounting device 130 and the mounting position and angle of this component is stored in the board master information storage area 162. For example, in this embodiment, table information having a configuration similar to the board information table 180a as shown in Fig. 7 is stored for each board as the circuit board master information.

Component master information for identifying the configuration of a component to be mounted onto a board by the component mounting device 130 is stored in the component master information storage area 163. For example, in this embodiment, table information having a configuration similar to the mounting component information table 181a as shown in Fig. 8 is stored as the component master information.

Information for identifying the resource available in the component mounting system 100 and the available number of a relevant resource is stored in the resource information storage area 164. For example, in this embodiment, table information having a configuration similar to the resource information table 182a as shown in Fig. 9 is stored as the resource information.

Information for identifying the communication address of the component mounting device 130, a resource, and the available number of this resource is stored in the device master information storage area 165. For example, in this embodiment, table information having a configuration similar to the device information table 183a as shown in Fig. 10 is stored for each component mounting device 130 as the device master information.

The control section 167 manages the information to be stored in the storage section 161. In particular, in this embodiment, the control section 167 controls the transmission of necessary information to the component mounting device 130 in response to a request from the component mounting device 130.

The communication section 168 transmits and receives information via the network 170.

The information storage device 160 described above can be also implemented, for example, with the computer 900 as shown in Fig. 11.

For example, the storage section 161 can be implemented by the CPU 901 using the memory 902 or the external storage device 903, the control section 167 can be implemented by loading a predetermined program, which is stored in the external storage device 903, into the memory 902 and causing the CPU 901 to execute this program, and the communication section 168 can be implemented by the CPU 901 using the communication device 908.

This predetermined program may be downloaded onto the external storage device 903 from the storage medium 904 via the read/write device 905 or from a network via the communication device 908, and then be loaded onto the memory 902 so as to be executed by the CPU 901. Moreover, this predetermined program may be loaded directly onto the memory 902 from the storage medium 904 via the read/write device 905 or from a network via the communication device 908 so as to be executed by the CPU 901.

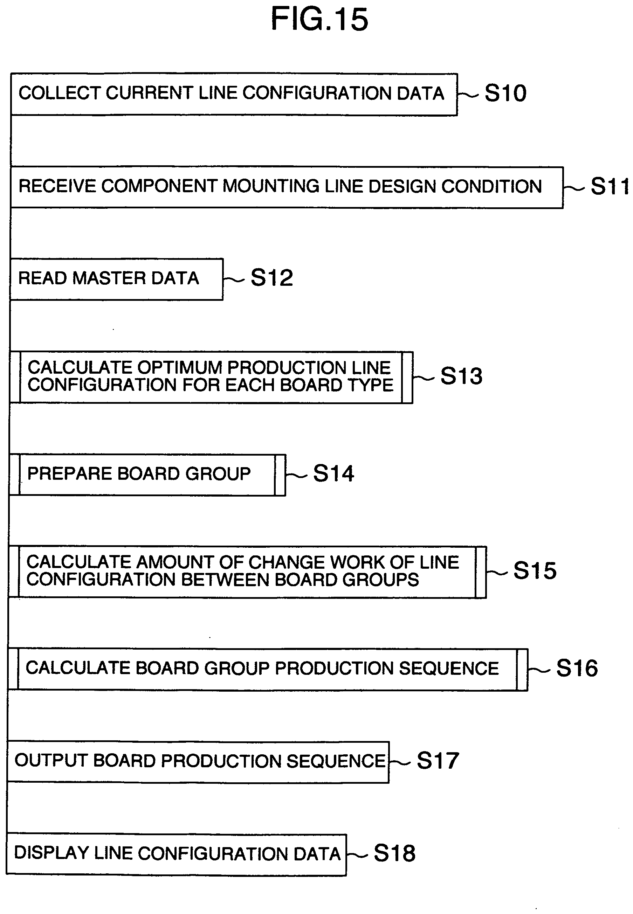

Fig. 15 is a PAD (Problem Analysis Diagram) showing an example of a component mounting line design procedure in the component mounting line design device 110.

In Step S10, the mounting information generation unit 120 of the component mounting line design device 110 instructs, via the communication section 126, each component mounting device 130 to transmit configuration data, thereby collecting from each component mounting device 130 the configuration data for identifying an order, in which the component mounting device 130 is arranged, the type of a head mounted at a mounting position of a mounting head, and the component feeder method. The mounting information generation unit 120 then generates from the collected configuration data the component mounting line information table 114a as shown in Fig. 5, and associates the configuration data with the information for identifying a current line configuration and the board type produced in the current line configuration, and stores these associated data and information in the component mounting line information storage area 114.

In Step S11, the mounting information generation unit 120 receives an input of a production plan and a design parameter via the input section 124 from a user of the component mounting line design device 110.

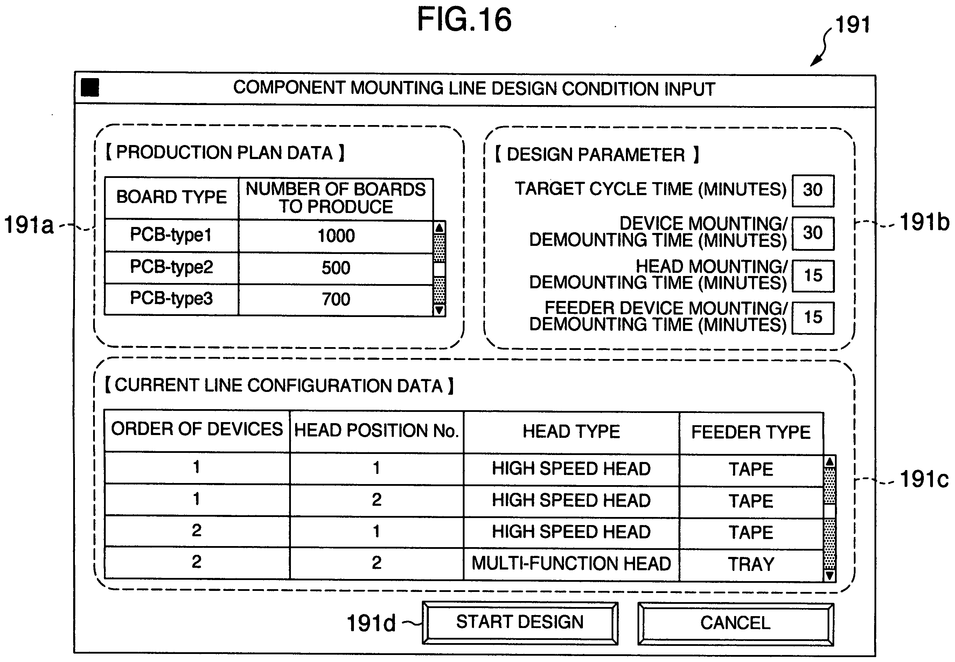

For example, the mounting information generation unit 120 displays a component mounting line design condition input screen 191 as shown in Fig. 16 (a schematic diagram of the component mounting line design condition input screen 191) in the output section 125 so as to receive an input of a production plan and a design parameter from a user via the input section 124.

As shown in the view, the component mounting line design condition input screen 191 includes a production schedule data input area 191a, a design parameter input area 191b, and a current line configuration data display area 191c.

The production schedule data input area 191 a receives an input of the information for identifying the type of a board to produce and the number of boards of this type to produce.

The design parameter input area 191b receives an input of the information for identifying a target cycle time which is a target value of the cycle time of the production of one board, a device mounting/demounting time which is a mounting/demounting time of the component mounting device 130 with respect to a component mounting line, a head mounting/demounting time which is a mounting/demounting time of a mounting head, and a feeder device mounting/demounting time which is a mounting/demounting time of a component feeder device, such as a cart or a tray.

Table information similar to the component mounting line information table 114a for identifying the configuration of a current component mounting line, which is stored in the component mounting line information storage area 114, is displayed in the current line configuration data display area 191c.

Then, the mounting information generation unit 120 receives an input of the information required for the production schedule data input area 191a and design parameter input area 191b, and receives an input of an execution instruction specifying a "design start instruction" area 191d, whereby the mounting information generation unit 120 stores the input information into the storage section 111 and then proceeds to the next step S12.

For example, the mounting information generation unit 120 generates the production plan information table 112a as shown in Fig. 3, stores the type and number of boards to produce, the input of which was received via the production schedule data input area 191 a, into the board type column 112b and "number of boards to produce" column 112c of the generated production plan information table 112a, leaves the production sequence column 112d blank, and stores a value of "0" into the "number of already produced boards" column 112e.

The mounting information generation unit 120 generates the design parameter information table 113a as shown in Fig. 4, and stores the information, the input of which was received via the design parameter input area 191b, into the target cycle time row 113b, the device mounting/demounting time row 113c, the head mounting/demounting time row 113d, and the feeder device mounting/demounting time row 113e of the generated design parameter information table 113a, respectively.

In Step S12, the mounting information generation unit 120 transmits the information for identifying the board type, the input of which was received in Step S 11, to the information storage device 160 via the communication section 126. The information storage device 160 returns the board information table 180a corresponding to the transmitted board type, the mounting component information table 181a as shown in Fig. 8 corresponding to a part code stored in the part code column 180f of the board information table 180a, the resource information table 182a as shown in Fig. 9, and the device information table 183a as shown in Fig. 10, to the component mounting line design device 110. The component mounting line design device 110 stores these received pieces of information into the temporary information storage area 116.

In Step S 13, for each type of a board to produce, the input of which was received in Step S 11, the mounting information generation unit 120 identifies, with the use of a known method, e.g., the method described in JP-A-2009-49440, a component mounting line, which satisfies the constraint of an available resource identified by the resource information table 182a stored in the temporary information storage area 116 and the cycle time of which satisfies a target cycle time identified by the design parameter information table 113a or is the shortest one. The mounting information generation unit 120 then associates the identified component mounting line with a board type as the component mounting line information table 114a and stores the associated information into the component mounting line information storage area 114. The mounting information generation unit 120 also calculates component mounting information including the arrangement of a component feeder unit with respect to each component mounting device 130, a component mounting sequence and the like and stores this information into the component mounting information storage area 115 as the component mounting information table 115a.

In Step S14, the production sequence calculation unit 121 prepares a board group of board types whose component mounting lines generated in Step S 13 are determined to be similar and stores the board group information for identifying the relevant board group into the temporary information storage area 116.

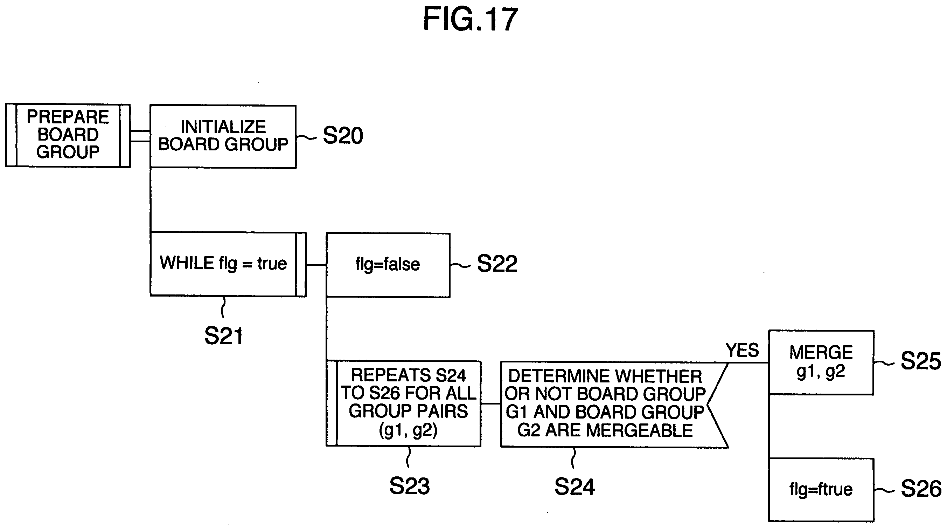

Fig. 17 is a PAD showing an example of generating the board group in Step S 14 of Fig. 15.

In Step S20, the production sequence calculation unit 121 initializes a board group. For example, in this embodiment, the board group is initialized by setting each of the board types produced in the "current line configuration" and the board types, the input of which was received as a production plan, to each one board group.

Note that, in this embodiment, with regard to the board type produced with the "current line configuration", a virtual board is used. For example, with regard to the board type produced with the "current line configuration", dummy data is used wherein the number of mounted components is "0" and the number of boards to produce is "0".

In Step S21, the production sequence calculation unit 121 repeats the processings of Steps S22 to S26 while a flag variable "flg" is true, the flag variable "flg" indicating whether or not the board groups have been merged.

In Step S22, the production sequence calculation unit 121 initializes the flag variable "flg" to false.

In Step S23, the production sequence calculation unit 121 selects all board group pairs (g1, g2) from a set of board groups and repeats the Steps S24 to S26.

In Step S24, the production sequence calculation unit 121 determines whether or not the board group g1 and board group g2 contained in a pair selected in Step S23 can be merged (i.e., whether or not the board group g1 and board group g2 are similar to each other). For example, in this embodiment, the component mounting line information table 114a for identifying a component mounting line which mounts the mounting board types belonging to the board group g1 and the board group g2 is acquired from the component mounting line information storage area 114, and if the number of the component mounting devices 130 contained in a component mounting line identified by the acquired component mounting line information table 114a are equal between the board group g1 and board group g2 and if the configuration of the component mounting line has an inclusive relation between the board group g1 and board group g2, then the board group g1 and board group g2 are determined as mergeable (similar). If the determination result is truth, the procedure moves to Step S25.

Here, among the board types contained in the board group g1 and board group g2, between board types having the largest numbers of head types and feeder types constituting a component mounting line, if the order of devices, the head position No., the head type, and the feeder type are equal or if either one of the component mounting lines has a configuration excluding the head type or the feeder type from the configuration of the other component mounting line, then the board group g1 and the board group g2 are determined as being in an inclusive relation.

In Step S25, the production sequence calculation unit 121 merges the board group g1 and the board group g2. For example, in order to generate a new board group using the board types contained in the board group g1 and the board group g2 and include this new board group into a set of board groups, the board groups corresponding to the board group g1 and the board group g2 are deleted from the set of board groups.

In Step S26, the production sequence calculation unit 121 sets a flag variable "flg" to be true.

In this manner, the production sequence calculation unit 121 prepares a board group.

Returning to Fig. 15, in Step S 15, the production sequence calculation unit 121 calculates an amount of change work of a line configuration between board groups, for all pairs of the board groups.

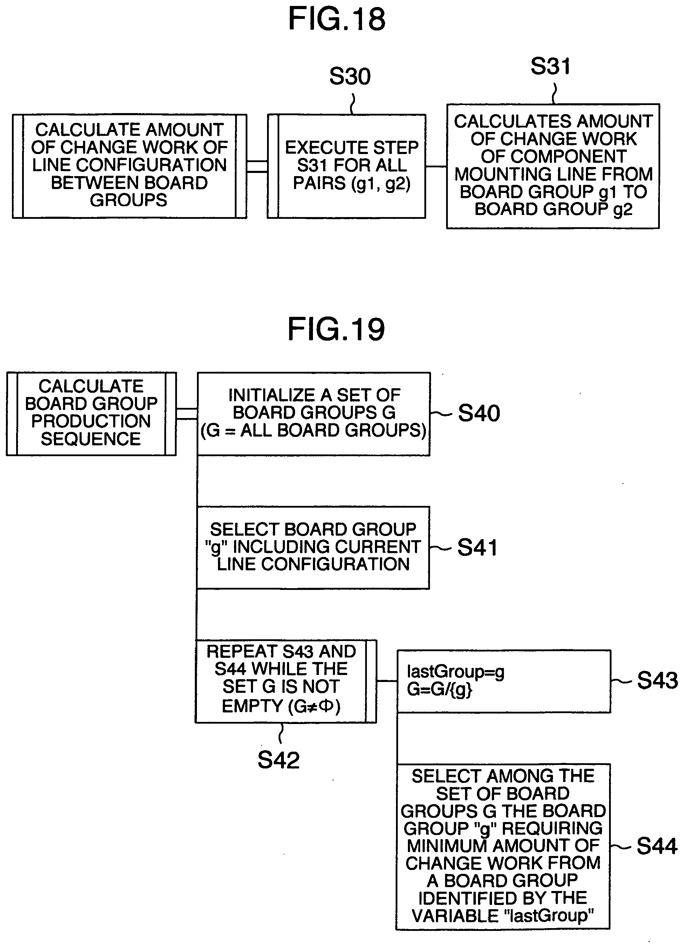

Here, Fig. 18 is a PAD showing an example of calculating the amount of change work of a line configuration between board groups, in Step S15.

In Step S30, the production sequence calculation unit 121 executes Step S31 with respect to all pairs (g1, g2) of the board groups contained in a set of board groups.

In Step S31, an amount of work required to change the configuration of a component mounting line during production of the board group g1 to the configuration of a component mounting line during production of the board group g2 (hereinafter, referred to as a line configuration change work amount W) is calculated. In this embodiment, as the line configuration change work amount W, a value calculated by Formula (1) below is used.

W = device mounting/demounting time × (number of times of device detachment + number of times of device attachment) + head mounting/demounting time × (number of times of head detachment + number of times of head attachment) + feeder type mounting/demounting time × (number of times of feeder type detachment + number of times of feeder device attachment) (1)

In this embodiment, a target for calculating the line configuration change work amount W is a board type having the largest number of head types and feeder types constituting a component mounting line among the board types contained in each of the board group g1 and the board group g2.

Moreover, in Formula (1), those stored in the device mounting/demounting time row 113c, head mounting/demounting time row 113d, and feeder device mounting/demounting time row 113e of the design parameter information table 113a stored in the design parameter information storage area 113 are used as the device mounting/demounting time, head mounting/demounting time, and feeder device mounting/demounting time, respectively.

Then, in Formula (1), the number of times of device detachment, the number of times of device attachment, the number of times of head detachment, the number of times of head attachment, the number of times of feeder type detachment, and the number of times of feeder device attachment are determined from a difference between a component mounting line corresponding to a board type which is a target for calculating the line configuration change work amount W in the board group g1 and a component mounting line corresponding to a board type which is a target for calculating the line configuration change work amount W in the board group g2.

For example, in Formula (1), if the difference between the maximum value in the order of devices of the component mounting line information table 114a corresponding to a board type which is a target for calculating the line configuration change work amount W in the board group g1 and the maximum value in the order of devices of the component mounting line information table 114a corresponding to a board type which is a target for calculating the line configuration change work amount W in the board group g2 is a positive value, then the number of times of device detachment is set to this difference value, otherwise "0".

That is, the number of times of device detachment is Max(number of devices during attachment of the board group g1 - number of devices during attachment of the board group g2, 0).

Moreover, in Formula (1), if the difference between the maximum value in the order of devices in the component mounting line information table 114a corresponding to a board type which is a target for calculating the line configuration change work amount W in the board group g2 and the maximum value in the order of devices of in the component mounting line information table 114a corresponding to a board type which is a target for calculating the line configuration change work amount W in the board group g1 is a positive value, then the number of times of device attachment is set to the value of this difference, otherwise "0".

That is, the number of times of device attachment is Max (number of boards during mounting of the board group g2 - number of boards during mounting of the board group g1, 0).

Furthermore, in Formula (1), the number of times of head detachment is obtained as follows:
(1) the number of records having different values (character strings) stored in the head type column 114d in the records having the same values stored in the "order of devices" column 114b and the head position No. column 114c, respectively, in the component mounting line information table 114a corresponding to a board type which is a target for calculating the line configuration change work amount W in the board group g1 and in the component mounting line information table 114a corresponding to a board type which is a target for calculating the line configuration change work amount W in the board group g2 is denoted by "nr1",
(2) a positive number among the numbers obtained by subtracting the number of records of the board group g2 from the number of records of the board group g1 in the records having the same value stored in the "order of devices" column 114b in the component mounting line information table 114a corresponding to a board type which is a target for calculating the line configuration change work amount W in the board group g1 and in the component mounting line information table 114a corresponding to a board type which is a target for calculating the line configuration change work amount W in the board group g2 is denoted by "nr2",
(3) the number of times of head detachment is equal to nr1 plus nr2.

That is, the number of times of head detachment is a value obtained by adding the number of deleted records to the number of records whose value in the head type column 114d has changed in the same device and head position in switching from the board group g1 to the board group g2.

Moreover, in Formula (1), the number of times of head attachment is obtained as follows:
(1) the number of records having different values (character strings) stored in the head type column 114d in the records having the same values stored in the "order of devices" column 114b and the head position No. column 114c in the component mounting line information table 114a corresponding to a board type which is a target for calculating the line configuration change work amount W in the board group g1 and in the component mounting line information table 114a corresponding to a board type which is a target for calculating the line configuration change work amount W in the board group g2 is denoted by "nr1",
(2) a positive number among the numbers obtained by subtracting the number of records of the board group g1 from the number of records of the board group g2 in the records having the same value stored in the "order of devices" column 114b in the component mounting line information table 114a corresponding to a board type which is a target for calculating the line configuration change work amount W in the board group g1 and in the component mounting line information table 114a corresponding to a board type which is a target for calculating the line configuration change work amount W in the board group g2 is denoted by "nr3 ",
(3) the number of times of head attachment is equal to nr1 plus nr3.

That is, the number of times of head attachment is a value obtained by adding the number of added records to the number of records whose value in the head type column 114d has changed in the same device and head position in switching from the board group g1 to the board group g2.

Furthermore, in Formula (1), the number of times of feeder type detachment is a value obtained as follows:
(1) the number of records having different values (character strings) stored in the feeder type column 114e in records having same values stored in the "order of devices" column 114b and the head position No. column 114c, respectively, in the component mounting line information table 114a corresponding to a board type which is a target for calculating the line configuration change work amount W in the board group g1 and in the component mounting line information table 114a corresponding to a board type which is a target for calculating the line configuration change work amount W in the board group g2 is denoted by "nr4".
(2) a positive number among the numbers obtained by subtracting the number of records of the board group g2 from the number of records of the board group g1 in the records having the same value stored in the "order of devices" column 114b in the component mounting line information table 114a corresponding to a board type which is a target for calculating the line configuration change work amount W in the board group g1 and in the component mounting line information table 114a corresponding to a board type which is a target for calculating the line configuration change work amount W in the board group g2 is denoted by "nr2",
(3) the number of times of feeder type detachment is equal nr4 plus nr2.

That is, the number of times of feeder device detachment is a value obtained by adding the number of deleted records to the number of records whose value has changed in the feeder type column 114e in the same device and head position in switching from the board group g1 to the board group g2.

Moreover, in Formula (1), the number of times of feeder device attachment is a value obtained as follows:
(1) the number of records having different values (character strings) stored in the feeder type column 114e in records having same values stored in the "order of devices" column 114b and the head position No. column 114c in the component mounting line information table 114a corresponding to a board type which is a target for calculating the line configuration change work amount W in the board group g1 and in the component mounting line information table 114a corresponding to a board type which is a target for calculating the line configuration change work amount W in the board group g2 is denoted by "nr4".
(2) a positive number among the numbers obtained by subtracting the number of records of the board group g1 from the number of records of the board group g2 in the records having the same value stored in the "order of devices" column 114b in the component mounting line information table 114a corresponding to a board type which is a target for calculating the line configuration change work amount W in the board group g1 and in the component mounting line information table 114a corresponding to a board type which is a target for calculating the line configuration change work amount W in the board group g2 is denoted by "nr3",
(3) the number of times of feeder device attachment is equal to nr4 plus nr3.

That is, the number of times of feeder device attachment is a value obtained by adding the number of added records to the number of records whose value in the feeder type column 114e has changed in the same device and head position in switching from the board group g1 to the board group g2.

Returning to Fig. 15, in Step S16, the production sequence calculation unit 121 calculates a production sequence of board groups.

Fig. 19 is a PAD showing an example of calculating the production sequence of the board groups in Step S16.

In Step S40, the production sequence calculation unit 121 initializes a set of board groups G with all of the board groups.

In Step S41, the production sequence calculation unit 121 selects a board group "g" including boards produced in the current line configuration, as a board group to produce first.

In Step S42, Steps S43 and S44 are repeated while the set G is not empty.

In Step S43, the production sequence calculation unit 121 sets a variable "LastGroup" indicative of a lastly selected group to the board group "g" and furthermore deletes the board group "g" from the set G

In Step S44, the production sequence calculation unit 121 selects, among the set G, the board group "g" wherein the amount of change work from a board group identified by the variable "LastGroup" is the minimum, as a board group to produce next (if there are board groups wherein the amount of change work is the same, then a board group may be selected at random (by using any method).

Thus, a production sequence of the board groups has been set, so that a component mounting line change plan with a small amount of change work of a component mounting line has been obtained.

Returning to Fig. 15, in Step S17 the production sequence calculation unit 121 stores the information for identifying a board production sequence into the production sequence column 112d of the production plan information table 112a based on the production sequence of the board groups calculated in Step S16. Here, the order of board types belonging to the same board group may be set at random (using any method).

In Step S18, the production sequence calculation unit 121 outputs the information for identifying a production sequence of the board groups calculated in Step S16 and a component mounting line in producing boards contained in each board group, to the output section 125.

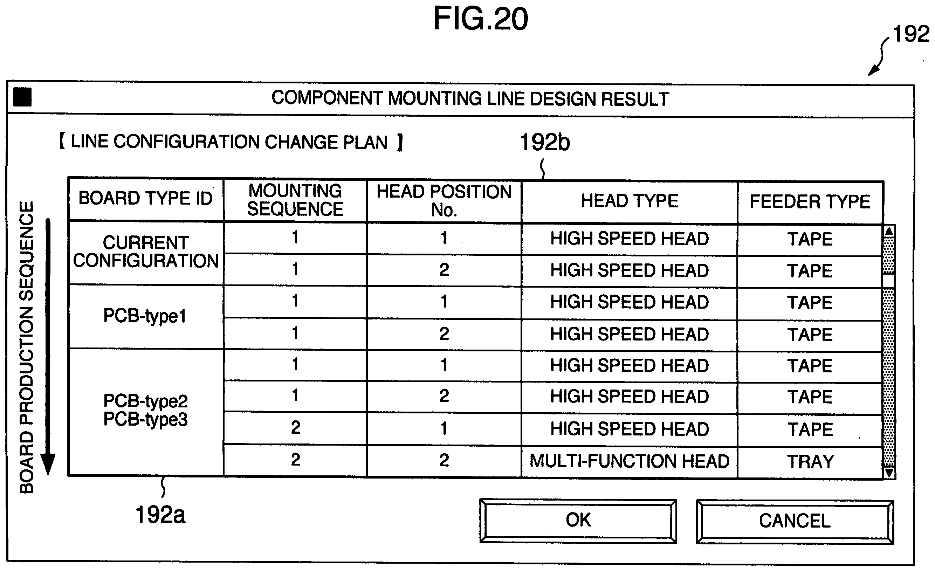

For example, the production sequence calculation unit 121 generates a component mounting line design result screen 192 as shown in Fig. 20 (a schematic diagram of the component mounting line design result screen 192), and outputs this to an output section 125.

Here, in the component mounting line design result screen 192, there are provided an area 192a for displaying board type information for identifying the board types, which are contained in each board group from upward to downward according to the calculated production sequence, and an area 192b for displaying the component mounting line information in producing a relevant type of board at a position corresponding to the information for identifying a board type of the area 192a.

As described above, according to the present invention, a production sequence of a board type with a small amount of change work can be identified.

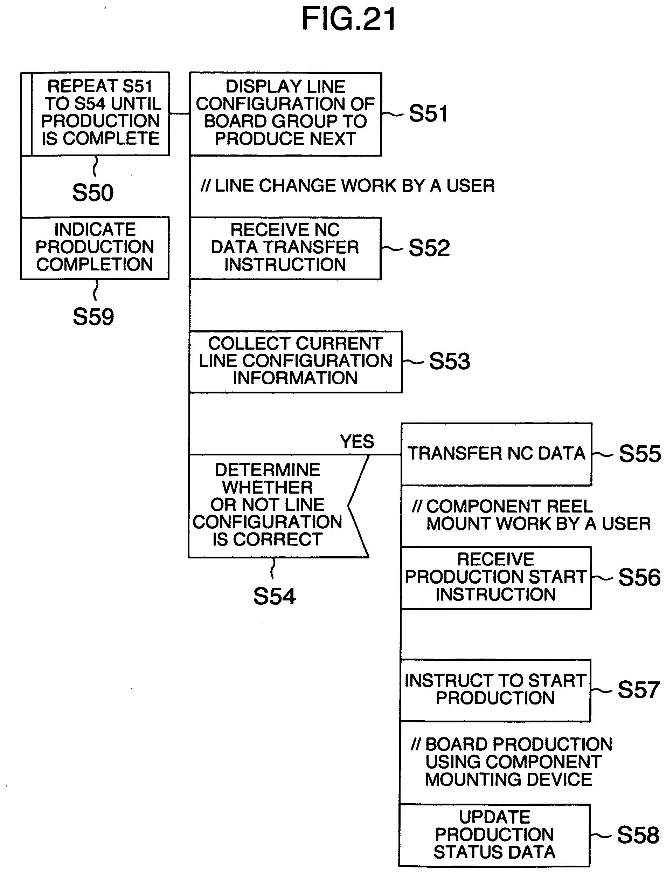

Fig. 21 is a PAD showing an example of the processing during board production in the component mounting system 100.

In Step S50, the production processing unit 122 of the component mounting line design device 110 repeats Steps S51 to S58 until the production of a board of a board type stored in the production plan information table 112a is complete.

In Step S51, the production processing unit 122 identifies a board type to produce next, using the production sequence column 112d and the board type column 112b of the production plan information table 112a, and extracts the component mounting line information table 114a corresponding to an identified board type from the component mounting line information storage area 114, and converts the format of the extracted component mounting line information table 114a into a predetermined display format, and outputs this component mounting line information table 114a to the output section 125.

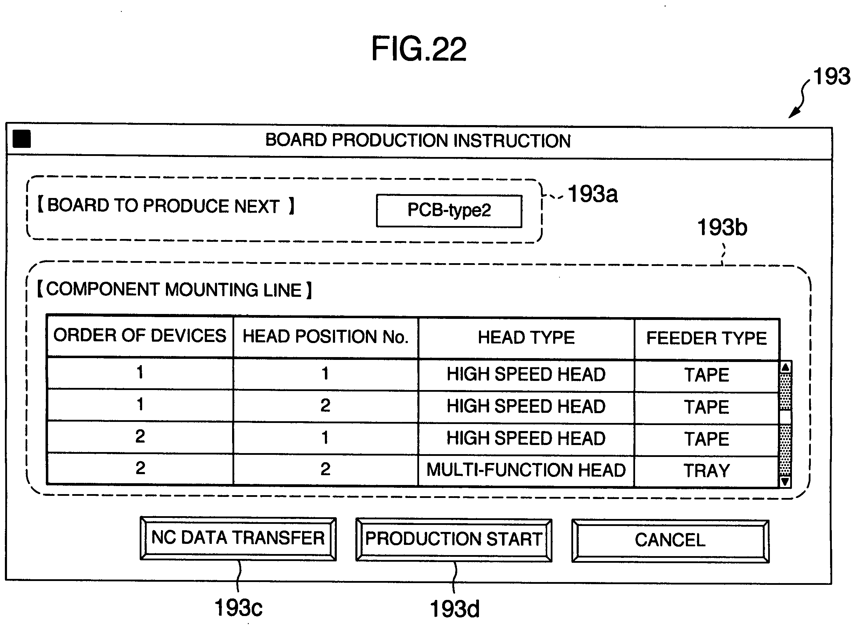

For example, the production processing unit 122 generates a board production instruction display screen 193 as shown in Fig. 22 (a schematic diagram of the board production instruction display screen 193) from the component mounting line information table 114a, and outputs this screen to the output section 125.

Here, the board production instruction display screen 193 includes an area for displaying a board to produce next 193a and a component mounting line display area 193b, wherein information for identifying a board type to produce next identified by the production plan information table 112a is displayed in the area for displaying a board to produce next 193a, and wherein information stored in the component mounting line information table 114a corresponding to a board type to produce next is displayed in the component mounting line display area 193b.

Such a board production instruction display screen 193 is output to the output section 125, whereby a user changes the line configuration of the board production line so as to be a line configuration displayed in the component mounting line display area 193b.

In Step S52, the production processing unit 122 receives an NC data transmission instruction from a user via the input section 124.

For example, the production processing unit 122 receives an input of an execution instruction specifying an NC data transmission instruction input area 193c of the board production instruction display screen 193, from a user via the input section 124, thereby receiving the NC data transmission instruction from the user.

In Step S53, the production processing unit 122 instructs, via the communication section 126, each component mounting device 130 to transmit configuration data, thereby collecting from each component mounting device 130 the configuration data for identifying an order in which the component mounting device 130 is arranged, the type of a head to be mounted at a mounting position of a mounting head, and the component feeder type.

In Step S54, the production processing unit 122 determines whether or not the component mounting line information table 114a corresponding to a board type to produce next identified in Step S51 coincides with the configuration data collected in Step S53, and if the component mounting line information table 114a coincides with the configuration data, then the procedure moves to Step S55.

In Step S55, the production processing unit 122 transmits a board type to produce next, the component mounting information table 115a corresponding to the board type to produce next, and the mounting component information table 181a to each component mounting device 130 via the communication section 126.

Here, the general control unit 136 of each component mounting device 130 stores the received component mounting information table 115a and mounting component information table 181a into the component mounting information storage area 132 and the mounting component information storage area 133, respectively.

Then, the general control unit 136 of each component mounting device 130 converts the formats of the received component mounting information table 115a and mounting component information table 181a to predetermined display formats, respectively, and outputs the resultant component mounting information table 115a and mounting component information table 181a to the output section 142.

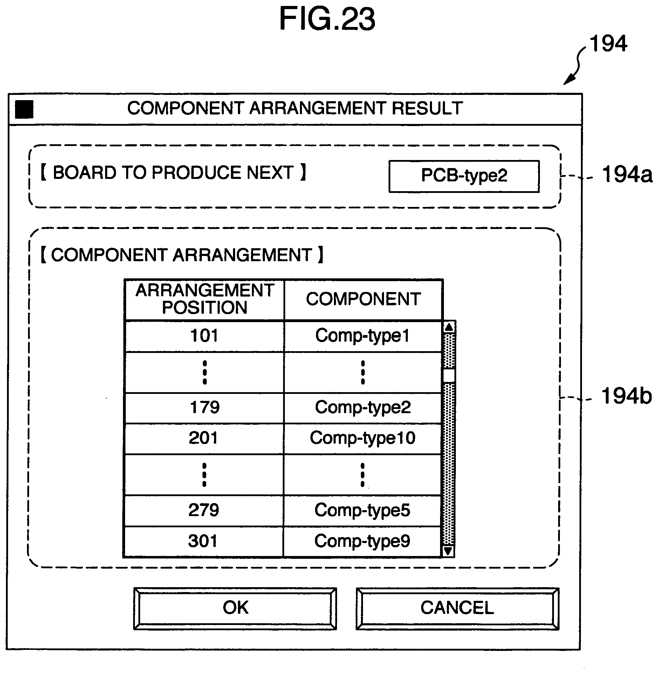

For example, the general control unit 136 of the component mounting device 130 generates a component arrangement result display screen 194 as shown in Fig. 23 (a schematic diagram of the component arrangement result display screen 194) from the received component mounting information table 115a and mounting component information table 181a, and outputs the same to the output section 142.

Here, the component arrangement result display screen 194 includes an area for displaying a board to produce next 194a and a component arrangement display area 194b, wherein the information for identifying a board type to produce next is displayed in the area for displaying a board to produce next 194a, and wherein the information for identifying the position of a component feeder unit and the information for identifying the type of a component to be arranged at a relevant position, which are extracted from the component mounting information table 115a and the mounting component information table 181a, are displayed in the component arrangement display area 194b.

Such a component arrangement result display screen 194 is output to the output section 142, whereby a user changes a component which is to be placed on the cart 150 or the multi-stage tray 152 of each component mounting device 130.

In Step S57, the production processing unit 122 of the component mounting line design device 110 receives an input of a production start instruction from a user via the input section 124.

For example, the production processing unit 122 receives an input of an execution instruction specifying a production start instruction input area 193d of the board production instruction display screen 193, from a user via the input section 124, thereby receiving an input of the production start instruction from the user.

In Step S57, the production processing unit 122 instructs each component mounting device 130 to start production, via the communication section 126.

In each component mounting device 130 having received such a production start instruction, the device driving unit 137 controls the component mounting section 139 and the component feeder section 140 to thereby produce boards.

Note that the general control unit 136 of each component mounting device 130 transmits the information for identifying the progress status (the number of already produced boards) of board production to the component mounting line design device 110 via the communication section 143.

In Step S58, the production processing unit 122 receives the information for identifying the progress status from the component mounting device 130 of the downstream end, thereby updating the "number of already produced boards" column 112e of the production plan information table 112a.

In Step S59, the production processing unit 122 outputs the information for identifying the completion of production of all boards to a user via the output section 125.

As described above, according to the present embodiment, a user can produce a desired circuit board in a short time because a board production sequence wherein the work time required to change a component mounting line configuration is as short as possible can be calculated. Note that, according to the embodiment of the present invention described above, assuming a component mounting line connecting the same type of component mounting devices to one other, only the mounting head type and the component feeder type are set to configurable options. However, the present invention is not limited to such an embodiment and can be similarly applied to cases where different types of component mounting devices are connected to one another, for example. If different types of component mounting devices are connected to one another, the information for identifying the type of a component mounting device may be managed in the component mounting line information table 114a.

Moreover, in the embodiment described above, the board master information, the component master information, the resource information, and the device master information are acquired from the information storage device 160. However, the present invention is not limited to such a configuration and these pieces of information may be stored also in the storage section 111 of the component mounting line design device 110, for example.

Furthermore, in the embodiment described above, the mounting information generation unit 120 of the component mounting line design device 110 generates the component mounting line information table 114a and the component mounting information table 115a. However, the present invention is not limited to such a configuration, and for example, these pieces of table information may be prepared by other device or a user input so as to be stored in the component mounting line information storage area 114 and the component mounting information storage area 115, respectively.

Note that, in the embodiment described above, between the board groups, if the number of component mounting device 130 contained in a component mounting line is equal and if the configuration of a component mounting line has an inclusive relation, then the board groups are determined as mergeable (similar) and the line configuration change work amount between the board groups which have been determined as mergeable is calculated. However, the line configuration change work amount may be calculated from the configuration of a component mounting line of each board type without performing such merging.

Moreover, in the embodiment described above, the line configuration change work time is calculated according to the number of the component mounting devices 130 contained in a component mounting line, the type of a mounting head attached to the component mounting device 130 and the number thereof, and the type of a component feeder device used in the component mounting device 130 and the number thereof. However, the present invention is not limited to such a configuration, and the line configuration change work time may be calculated using at least one of the above-described types and numbers or an arbitrary combination thereof, for example

Moreover, the method of determining a generation sequence of board types is not limited to the above-described one. For example, a total value of the amount of work in the generation sequence of all of the board types may be calculated in advance so that the board types may be generated in such a generation sequence that the total value becomes the minimum, or an optimum solution of the sequence may be calculated using a local search method, such as a 2-opt method.

## Claims

1. A component mounting line design device (110), comprising:
a storage section (111) which stores component mounting line information for identifying, for each board type, an order of arranging a component mounting device (130: 130A, 130B) in producing a relevant type of board (190), a position where a mounting head (145A, 145B) is attached to the component mounting device (130: 130A, 130B), a type of the mounting head (145A, 145B) mounted at the position, and a type of a component feeder device (140, 151, 153) of the component mounting device (130: 130A, 130B); and
a control section (118), wherein
the control section (118) is configured to
prepare board groups of board types, and
calculate, for each pair of the board groups of the board types, an amount of work in changing a component mounting line identified by component mounting line information corresponding to one board type (g1) contained in one board group contained in the pair to a component mounting line identified by component mounting line information corresponding to other board type (g2) contained in other board group contained in the pair,
the amount of work is a work time required to change a component mounting line configuration,
the change work time is calculated according to at least one of, or an arbitrary combination of the number of the component mounting devices contained in a component mounting line, the type of a mounting head attached to the component mounting device (130) and the number thereof, and the type of a component feeder device used in the component mounting device (130) and the number thereof as well as the mounting / demounting times of the component mounting devices, the mounting heads and the feeder types,
the control section (118) is further configured to
initialize a set of board groups (G) with all the board groups,
select a board group including boards produced in a current line configuration, as a board group to produce first,
repeat while the set of board groups (G) is not empty
deleting the lastly selected board group (g) from the set of board groups (G),
selecting, among the set of board groups (G), a board group which the amount of change work from the lastly selected board group (g) is the minimum, as a board group to produce next, and
thereby identify an order of putting into the component mounting line of the board type so that a total value of the amount of work becomes minimum.

2. The component mounting line design device (110) according to claim 1, wherein
the control section (118), when component mounting lines identified by the component mounting line information corresponding to the respective board types are equal or when numbers of the component mounting devices (130: 130A, 130B) contained in component mounting lines identified by the component mounting line information corresponding to the respective board types are equal and configurations of the component mounting lines have an inclusive relation between the respective board types, generates a board group comprising the board types.

3. The component mounting line design device (110) according to any one of claim 1 or 2, wherein the control section (118) uses, as one board type contained in one board group contained in the pair and other board type contained in other board group contained in the pair, a board type having the largest number of mounting heads (145A, 145B) and component feeder devices (140, 151, 153) contained in a component mounting line identified by the component mounting line information corresponding to a board type contained in the relevant board group.

4. The component mounting line design device (110) according to any one of claims 1 to 3, wherein
if a difference between a number of the component mounting devices (130: 130A, 130B) contained in a component mounting line identified by component mounting line information corresponding to the one board type (g1) and a number of the component mounting devices (130: 130A, 130B) contained in a component mounting line identified by the component mounting line information corresponding to the other board type (g2) is positive, the control section (118) is adapted to calculate number of times of device detachment multiplied by the device demounting time and add it to the work time, and
if a difference between a number of the component mounting devices (130: 130A, 130B) contained in a component mounting line identified by component mounting line information corresponding to the other board group (g2) and a number of the component mounting devices (130: 130A, 130B) contained in a component mounting line identified by the component mounting line information corresponding to the one board group (g1) is positive, the control section (118) is adapted to calculate device mounting time multiplied by number of times of device attachment and add it to the work time.

5. The component mounting line design device (110) according to any one of claims 1 to 4, wherein
a number of times of mounting head (145A, 145B) detachment in switching from the one board group (g1) to the other board group(g2) is determined, then the control section (118) is adapted to calculate head demounting time multiplied by the number of times of mounting head (145A, 145B) detachment and add it to the work time, and
a number of times of mounting head (145A, 145B) attachment in switching from the one board group (g1) to the other board group (g2) is determined, then the control section (118) is adapted to calculate head mounting time multiplied by the number of times of head attachment and add it to the work time.

6. The component mounting line design device (110) according to any one of claims 1 to 5, wherein
a number of times of types of component feeder device (140, 151, 153) detachment in switching from the one board group (g1) to the other board group (g2) is determined, then the control section (118) is adapted to calculate feeder type demounting time multiplied by the number of times of types of component feeder device (140, 151, 153) detachment and add it to the work time, and
a number of times of types of component feeder device (140, 151, 153) attachment in switching from the one board group (g1) to the other board group (g2) is determined, then the control section (118) is adapted to calculate feeder type mounting time multiplied by the times of types of component feeder device (140, 151, 153) attachment and add it to the work time.

7. A component mounting system, comprising: a component mounting line design device (110) according to any one of claims 1 to 6; and a component mounting device (130: 130A, 130B) which produces a board corresponding to a relevant board type in a board type input sequence defined by the component mounting line design device (110).

8. A program causing a computer (900) to function as a storage unit (111) adapted to store component mounting line information for identifying, for each board type, an order of arranging component mounting devices (130: 130A, 130B) in producing the board type, a position where a mounting head (145A, 145B) is attached to the component mounting device (130: 130A, 130B), a type of the mounting head (145A, 145B) mounted at the position, and a type of a component feeder device (140, 151, 153) of the component mounting device (130: 130A, 130B), and
as a control unit (118),
wherein
the program causes the control unit (118)
prepare board groups of board types, and
calculate, for each pair of the board groups of the board types, an amount of work in changing a component mounting line identified by component mounting line information corresponding to one board type contained in one board group (g1) contained in the pair to a component mounting line identified by component mounting line information corresponding to other board type contained in other board group (g2) contained in the pair,
the amount of work is a work time required to change a component mounting line configuration,
the change work time is calculated according to at least one of, or an arbitrary combination of the number of the component mounting devices contained in a component mounting line, the type of a mounting head attached to the component mounting device (130) and the number thereof, and the type of a component feeder device used in the component mounting device (130) and the number thereof as well as the mounting / demounting times of the component mounting devices, the mounting heads and the feeder types,
the program further causes the control unit (118)
initialize a set of board groups (G) with all the board groups,
select a board group including boards produced in a current line configuration, as a board group to produce first,
repeat while the set of board groups (G) is not empty
deleting the lastly selected board group (g) from the set of board groups (G),
selecting, among the set of board groups (G), a board group which the amount of change work from the lastly selected board group (g) is the minimum, as a board group to produce next, and
thereby identify an order of putting into the component mounting line of the board type so that a total value of the amount of work becomes minimum.

9. The program according to claim 8, wherein
the control unit (118), when component mounting lines identified by the component mounting line information corresponding to the respective board types are equal or when numbers of the component mounting devices (130: 130A, 130B) contained in component mounting lines identified by the component mounting line information corresponding to the respective board types are equal and configurations of the component mounting lines have an inclusive relation between the respective board types, generate a board group comprising the board types.

10. The program according to any one of claim 8 or 9, wherein as one board type contained in one board group contained in the pair and other board type contained in other board group contained in the pair, the control unit (118) uses a board type having the largest number of mounting heads (145A, 145B) and component feeder devices (140, 151, 153) contained in a component mounting line identified by the component mounting line information corresponding to a board type contained in the relevant board group.

11. The program according to any one of claims 8 to 10, wherein
if a difference between a number of the component mounting devices (130: 130A, 130B) contained in a component mounting line identified by component mounting line information corresponding to the one board type (g1) and a number of the component mounting device (130: 130A, 130B) contained in a component mounting line identified by the component mounting line information corresponding to the other board type (g2) is positive, the control unit (118) is adapted to calculate number of times of device detachment multiplied by the device demounting time and add it to the work time, and
if a difference between a number of the component mounting devices (130: 130A, 130B) contained in a component mounting line identified by component mounting line information corresponding to the other board group (g2) and a number of the component mounting devices (130: 130A, 130B) contained in a component mounting line identified by the component mounting line information corresponding to the one board group (g1) is positive, the control unit (118) is adapted to calculate device mounting time multiplied by number of times of device attachment and add it to the work time.

12. The program according to any one of claims 8 to 11, wherein
a number of times of mounting head (145A, 145B) detachment in switching from the one board group (g1) to the other board group (g2) is determined, then the control unit (118) is adapted to calculate head demounting time multiplied by the number of times of mounting head (145A 145B) detachment and add it to the work time, and
a number of times of mounting head (145A, 145B) attachment in switching from the one board group (g1) to the other board group (g2) is determined, then the control unit (118) is adapted to calculate head mounting time multiplied by the number of times of head attachment and add it to the work time.

13. The program according to any one of claims 8 to 12, wherein
a number of times of types of component feeder device (140, 151, 153) detachment in switching from the one board group (g1) to the other board group (g2) is determined, then the control unit (118) is adapted to calculate feeder type demounting time multiplied by the number of times of types of component feeder device (140, 151, 153) detachment and add it to the work time, and
a number of times of types of component feeder device (140, 151, 153) attachment in switching from the one board group (g1) to the other board group (g2) is determined, then the control unit (118) is adapted to calculate feeder type mounting time multiplied by the times of types of component feeder device(140, 151, 153) attachment and add it to the work time.

## Patentansprüche

1. Vorrichtung (110) zum Konzipieren einer Komponentenmontagestraße, die umfasst:
einen Speicherabschnitt (111), der Komponentenmontagestraßeninformationen zur Identifizierung einer Anordnungsreihenfolge einer Komponentenmontagevorrichtung (130: 130A, 130B) bei der Herstellung eines relevanten Platinentyps (190), einer Position, an welcher ein Montagekopf (145A, 145B) an der Komponentenmontagevorrichtung (130: 130A, 130B) angebracht wird, eines Typs des an der Position montierten Montagekopfs (145A, 145B) und eines Typs einer Komponentenzuführungsvorrichtung (140, 151, 153) der Komponentenmontagevorrichtung (130: 130A, 130B) für jeden Platinentyp speichert; und
einen Steuerabschnitt (118), wobei
der Steuerabschnitt (118) konfiguriert ist, um
Platinengruppen von Platinentypen vorzubereiten, und
für jedes Paar der Platinengruppen der Platinentypen eine Arbeitsmenge für die Änderung einer Komponentenmontagestraße, die durch die Komponentenmontagestraßeninformationen, die einem Platinentyp (g1) entsprechen, der in einer Platinengruppe enthalten ist, die in dem Paar enthalten ist, in eine Komponentenmontagestraße, die durch die Komponentenmontagestraßeninformationen, die einem anderen Platinentyp (g2) entsprechen, der in der anderen Platinengruppe enthalten ist, die in dem Paar enthalten ist, zu berechnen,
wobei die Arbeitsmenge eine Arbeitszeit ist, die benötigt wird, um eine Konfiguration einer Komponentenmontagestraße zu ändern,
wobei die Änderungsarbeitszeit gemäß wenigstens einer oder einer beliebigen Kombination der Anzahl der Komponentenmontagevorrichtungen, die in einer Komponentenmontagestraße enthalten sind, des Typs eines an der Komponentenmontagevorrichtung (130) angebrachten Montagekopfs und dessen Anzahl und des Typs einer Komponentenzuführungsvorrichtung, die in der Komponentenmontagestraße (130) verwendet wird, und deren Anzahl ebenso wie der Montage-/Demontagezeiten der Komponentenmontagevorrichtungen, der Montageköpfe und der Zuführungstypen berechnet wird,
wobei der Steuerabschnitt (118) ferner konfiguriert ist, um
einen Satz von Platinengruppen (G) mit all den Platinengruppen zu initialisieren,
eine Platinengruppe mit Platinen, die in einer aktuellen Straßenkonfiguration hergestellt wurde, als eine Platinengruppe, die zuerst hergestellt werden soll, auszuwählen,
während der Satz von Platenengruppen (G) nicht leer ist, zu wiederholen:
Löschen der zuletzt ausgewählten Platinengruppe (g) aus dem Satz von Platinengruppen (G),
Auswählen aus dem Satz von Platinengruppen (G) einer Platinengruppe, bei der die Menge der Änderungsarbeit von der zuletzt ausgewählten Platinengruppe (g) minimal ist, als eine Platinengruppe, die als nächstes hergestellt werden soll, und
dabei eine Reihenfolge des Bringens des Platinentyps in die Komponentenmontagestraße zu bestimmen, so dass ein Gesamtwert der Arbeitsmenge minimal wird.

2. Vorrichtung (110) zum Konzipieren einer Komponentenmontagestraße nach Anspruch 1, wobei
der Steuerabschnitt (118), wenn Komponentenmontagestraßen, die durch die Komponentenmontagestraßeninformationen, die den jeweiligen Platinentypen entsprechen, identifiziert werden, gleich sind, oder wenn die Anzahlen der Komponentenmontagevorrichtungen (130: 130A, 130B), die in den Komponentenmontagestraßen enthalten sind, die durch die Komponentenmontagestraßeninformationen, die den jeweiligen Platinentypen entsprechen, identifiziert werden, gleich sind und Konfigurationen der Komponentenmontagestraßen eine Inklusivrelation zwischen den jeweiligen Platinentypen haben, eine Platinengruppe erzeugt, welche die Platinentypen enthält.

3. Vorrichtung (110) zum Konzipieren einer Komponentenmontagestraße nach einem der Ansprüche 1 oder 2, wobei der Steuerabschnitt (118) als einen Platinentyp, der in der einen Platinengruppe enthalten ist, die in dem Paar enthalten ist, und den anderen Platinentyp, der in der anderen Platinengruppe enthalten ist, die in dem Paar enthalten ist, einen Platinentyp mit der größten Anzahl von Montageköpfen (145A, 145B) und Komponentenzuführungsvorrichtungen (140, 151, 153), die in einer Komponentenmontagestraße enthalten sind, die durch die Komponentenmontagestraßeninformationen, die einem Platinentyp entsprechen, der in der relevanten Platinengruppe enthalten ist, identifiziert werden, verwendet.

4. Vorrichtung (110) zum Konzipieren einer Komponentenmontagestraße nach einem der Ansprüche 1 bis 3, wobei
wenn eine Differenz zwischen einer Anzahl der Komponentenmontagevorrichtungen (130: 130A, 130B), die in einer Komponentenmontagestraße enthalten sind, die durch Komponentenmontagestraßeninformationen, die dem einen Platinentyp (g1) entsprechen, identifiziert wird, und einer Anzahl der Komponentenmontagevorrichtungen (130: 130A, 130B), die in einer Komponentenmontagestraße enthalten sind, die durch Komponentenmontagestraßeninformationen, die dem anderen Platinentyp (g2) entsprechen, identifiziert wird, positiv ist, der Steuerabschnitt (118) geeignet ist, die Anzahl von Malen, die eine Vorrichtung abgenommen wird, multipliziert mit der Vorrichtungsdemontagezeit zu berechnen und dies zu der Arbeitszeit zu addieren, und
wenn eine Differenz zwischen einer Anzahl der Komponentenmontagevorrichtungen (130: 130A, 130B), die in einer Komponentenmontagestraße enthalten sind, die durch Komponentenmontagestraßeninformationen, die der anderen Platinengruppe (g2) entsprechen, identifiziert wird, und einer Anzahl der Komponentenmontagevorrichtungen (130: 130A, 130B), die in einer Komponentenmontagestraße enthalten sind, die durch Komponentenmontagestraßeninformationen, die der einen Platinengruppe (g1) entsprechen, identifiziert wird, positiv ist, der Steuerabschnitt (118) geeignet ist, die Vorrichtungsmontagezeit multipliziert mit der Anzahl der Male der Vorrichtungsanbringung zu berechnen und dies zu der Arbeitszeit zu addieren.

5. Vorrichtung (110) zum Konzipieren einer Komponentenmontagestraße nach einem der Ansprüche 1 bis 4, wobei
eine Anzahl von Malen, die ein Montagekopf (145A, 145B) beim Umschalten von der einen Platinengruppe (g1) auf die andere Platinengruppe (g2) abgenommen wird, bestimmt wird, der Steuerabschnitt (118) dann geeignet ist, die Kopfdemontagezeit multipliziert mit der Anzahl der Male, die ein Montagekopf (145A, 145B) abgenommen wird, zu berechnen und dies zu der Arbeitszeit zu addieren, und
eine Anzahl von Malen, die ein Montagekopf (145A, 145B) beim Umschalten von der einen. Platinengruppe (g1) auf die andere Platinengruppe (g2) angebracht wird, bestimmt wird, der Steuerabschnitt (118) dann geeignet ist, die Kopfmontagezeit multipliziert mit der Anzahl der Male, die der Montagekopf angebracht wird, zu berechnen und dies zu der Arbeitszeit zu addieren.

6. Vorrichtung (110) zum Konzipieren einer Komponentenmontagestraße nach einem der Ansprüche 1 bis 5, wobei
eine Anzahl von Malen, die Komponentenzuführungsvorrichtungstypen (140, 151, 153) beim Umschalten von der einen Platinengruppe (g1) auf die andere Platinengruppe (g2) abgenommen werden, bestimmt wird, der Steuerabschnitt (118) dann geeignet ist, die Zuführungstypdemontagezeit multipliziert mit der Anzahl der Male, die Komponentenzuführungsvorrichtungstypen (140, 151, 153) abgenommen werden, zu berechnen und dies zu der Arbeitszeit zu addieren, und
eine Anzahl von Malen, die Komponentenzuführungsvorrichtungstypen (140, 151, 153) beim Umschalten von der einen Platinengruppe (g1) auf die andere Platinengruppe (g2) angebracht werden, bestimmt wird, der Steuerabschnitt (118) dann geeignet ist, die Montagezeit der Zuführungstypen multipliziert mit der Anzahl der Male, die Komponentenzuführungsvorrichtungstypen (140, 151, 153) angebracht werden, zu berechnen und dies zu der Arbeitszeit zu addieren.

7. Komponentenmontagesystem, das umfasst: eine Vorrichtung (110) zum Konzipieren einer Komponentenmontagestraße nach einem der Ansprüche 1 bis 6; und eine Komponentenmontagevorrichtung (130: 130A, 130B), die eine Platine, die einem relevanten Platinentyp entspricht, in einer Platinentypeingangsabfolge herstellt, die durch die Vorrichtung (110) zum Konzipieren einer Komponentenmontagestraße bestimmt wird.

8. Programm, das bewirkt, dass ein Computer (900) als eine Speichereinheit (111) arbeitet, die geeignet ist, Komponentenmontagestraßeninformationen zur Identifizierung einer Anordnungsreihenfolge einer Komponentenmontagevorrichtung (130: 130A, 130B) bei der Herstellung des Platinentyps, einer Position, an welcher ein Montagekopf (145A, 145B) an der Komponentenmontagevorrichtung (130: 130A, 130B) angebracht wird, eines Typs des an der Position montierten Montagekopfs (145A, 145B) und eines Typs einer Komponentenzuführungsvorrichtung (140, 151, 153) der Komponentenmontagevorrichtung (130: 130A, 130B) für jeden Platinentyp zu speichern; und
eine Steuereinheit (118), wobei
das Programm bewirkt, dass die Steuereinheit (118)
Platinengruppen von Platinentypen vorbereitet, und
für jedes Paar der Platinengruppen der Platinentypen eine Arbeitsmenge für die Änderung einer Komponentenmontagestraße, die durch Komponentenmontagestraßeninformationen, die einem Platinentyp entsprechen, der in einer Platinengruppe (g1) enthalten ist, die in dem Paar enthalten ist, in eine Komponentenmontagestraße, die durch die Komponentenmontagestraßeninformationen, die einem anderen Platinentyp entsprechen, der in der anderen Platinengruppe (g2) enthalten ist, die in dem Paar enthalten ist, berechnet,
wobei die Arbeitsmenge eine Arbeitszeit ist, die benötigt wird, um eine Konfiguration einer Komponentenmontagestraße zu ändern,
wobei die Änderungsarbeitszeit gemäß wenigstens einer oder einer beliebigen Kombination der Anzahl der Komponentenmontagevorrichtungen, die in einer Komponentenmontagestraße enthalten sind, des Typs eines an der Komponentenmontagevorrichtung (130) angebrachten Montagekopfs und dessen Anzahl und des Typs einer Komponentenzuführungsvorrichtung, die in der Komponentenmontagestraße (130) verwendet wird, und deren Anzahl ebenso wie der Montage-/Demontagezeiten der Komponentenmontagevorrichtungen, der Montageköpfe und der Zuführungstypen berechnet wird,
wobei das Programm ferner bewirkt, dass die Steuereinheit (118) einen Satz von Platinengruppen (G) mit all den Platinengruppen initialisiert,
eine Platinengruppe mit Platinen, die in einer aktuellen Straßenkonfiguration hergestellt wurde, als eine Platinengruppe, die zuerst hergestellt werden soll, auswählt,
während der Satz von Platenengruppen (G) nicht leer ist, wiederholt:
Löschen der zuletzt ausgewählten Platinengruppe (g) aus dem Satz von Platinengruppen (G),
Auswählen aus dem Satz von Platinengruppen (G) einer Platinengruppe, bei der die Menge der Änderungsarbeit von der zuletzt ausgewählten Platinengruppe (g) minimal ist, als eine Platinengruppe, die als nächstes hergestellt werden soll, und
dabei eine Reihenfolge des Bringens des Platinentyps in die Komponentenmontagestraße bestimmt, so dass ein Gesamtwert der Arbeitsmenge minimal wird.

9. Programm nach Anspruch 8, wobei
die Steuereinheit (118), wenn Komponentenmontagestraßen, die durch die Komponentenmontagestraßeninformationen, die den jeweiligen Platinentypen entsprechen, identifiziert werden, gleich sind, oder wenn die Anzahlen der Komponentenmontagevorrichtungen (130: 130A, 130B), die in den Komponentenmontagestraßen enthalten sind, die durch die Komponentenmontagestraßeninformationen, die den jeweiligen Platinentypen entsprechen, identifiziert werden, gleich sind und Konfigurationen der Komponentenmontagestraßen eine Inklusivrelation zwischen den jeweiligen Platinentypen haben, eine Platinengruppe erzeugt, welche die Platinentypen enthält.

10. Programm nach einem der Ansprüche 8 oder 9, wobei die Steuereinheit (118) als einen Platinentyp, der in der einen Platinengruppe enthalten ist, die in dem Paar enthalten ist, und den anderen Platinentyp, der in der anderen Platinengruppe enthalten ist, die in dem Paar enthalten ist, einen Platinentyp mit der größten Anzahl von Montageköpfen (145A, 145B) und Komponentenzuführungsvorrichtungen (140, 151, 153), die in einer Komponentenmontagestraße enthalten sind, die durch die Komponentenmontagestraßeninformationen, die einem Platinentyp entsprechen, der in der relevanten Platinengruppe enthalten ist, identifiziert werden, verwendet.

11. Programm nach einem der Ansprüche 8 bis 10, wobei
wenn eine Differenz zwischen einer Anzahl der Komponentenmontagevorrichtungen (130: 130A, 130B), die in einer Komponentenmontagestraße enthalten sind, die durch Komponentenmontagestraßeninformationen, die dem einen Platinentyp (g1) entsprechen, identifiziert wird, und einer Anzahl der Komponentenmontagevorrichtungen (130: 130A, 130B), die in einer Komponentenmontagestraße enthalten sind, die durch Komponentenmontagestraßeninformationen, die dem anderen Platinentyp (g2) entsprechen, identifiziert wird, positiv ist, die Steuereinheit (118) geeignet ist, die Anzahl von Malen, die eine Vorrichtung abgenommen wird, multipliziert mit der Vorrichtungsdemontagezeit zu berechnen und dies zu der Arbeitszeit zu addieren, und
wenn eine Differenz zwischen einer Anzahl der Komponentenmontagevorrichtungen (130: 130A, 130B), die in einer Komponentenmontagestraße enthalten sind, die durch Komponentenmontagestraßeninformationen, die der anderen Platinengruppe (g2) entsprechen, identifiziert wird, und einer Anzahl der Komponentenmontagevorrichtungen (130: 130A, 130B), die in einer Komponentenmontagestraße enthalten sind, die durch Komponentenmontagestraßeninformationen, die der einen Platinengruppe (g1) entsprechen, identifiziert wird, positiv ist, der Steuereinheit (118) geeignet ist, die Vorrichtungsmontagezeit multipliziert mit der Anzahl der Male der Vorrichtungsanbringung zu berechnen und dies zu der Arbeitszeit zu addieren.

12. Programm nach einem der Ansprüche 8 bis 11, wobei
eine Anzahl von Malen, die ein Montagekopf (145A, 145B) beim Umschalten von der einen Platinengruppe (g1) auf die andere Platinengruppe (g2) abgenommen wird, bestimmt wird, die Steuereinheit (118) dann geeignet ist, die Kopfdemontagezeit multipliziert mit der Anzahl der Male, die ein Montagekopf (145A, 145B) abgenommen wird, zu berechnen und dies zu der Arbeitszeit zu addieren, und
eine Anzahl von Malen, die ein Montagekopf (145A, 145B) beim Umschalten von der einen Platinengruppe (g1) auf die andere Platinengruppe (g2) angebracht wird, bestimmt wird, der Steuerabschnitt (118) dann geeignet ist, die Kopfmontagezeit multipliziert mit der Anzahl der Male, die ein Montagekopf angebracht wird, zu berechnen und dies zu der Arbeitszeit zu addieren.

13. Programm nach einem der Ansprüche 8 bis 12, wobei
eine Anzahl von Malen, die Komponentenzuführungsvorrichtungstypen (140, 151, 153) beim Umschalten von der einen Platinengruppe (g1) auf die andere Platinengruppe (g2) abgenommen werden, bestimmt wird, die Steuereinheit (118) dann geeignet ist, die Zuführungstypdemontagezeit multipliziert mit der Anzahl der Male, die Komponentenzuführungsvorrichtungstypen (140, 151, 153) abgenommen werden, zu berechnen und dies zu der Arbeitszeit zu addieren, und
eine Anzahl von Malen, die Komponentenzuführungsvorrichtungstypen (140, 151, 153) beim Umschalten von der einen Platinengruppe (g1) auf die andere Platinengruppe (g2) angebracht werden, bestimmt wird, der Steuerabschnitt (118) dann geeignet ist, die Montagezeit der Zuführungstypen multipliziert mit der Anzahl der Male, die die Komponentenzuführungsvorrichtungstypen (140, 151, 153) angebracht werden, zu berechnen und dies zu der Arbeitszeit zu addieren.

## Revendications

1. Dispositif de design de ligne d'assemblage de composant (110), comprenant :
une section de stockage (111) qui stocke des informations de la ligne d'assemblage de composant pour identifier, pour chaque type de panneau, un ordre d'agencement du dispositif d'assemblage du composant (130 : 130A, 130B) dans la production d'un type de panneau (190) pertinent, une position où une tête d'assemblage (145A, 145) est fixée au dispositif d'assemblage de composant (130 : 130A, 130B), un type de la tête d'assemblage (145A, 145B) monté à la position, et un type de dispositif d'alimentation de composant (140, 151,153) du dispositif d'assemblage de composant (130 : 130A, 130B) ; et
une section de commande (118), dans laquelle
la section de commande (118) est configurée pour
préparer les groupes de panneaux de types de panneau, et
calculer, pour chaque paire de groupes de panneaux des types de panneau, une quantité de travail pour la modification d'une ligne d'assemblage de composant identifiée par des informations de la ligne d'assemblage de composant correspondant à un type de panneau (g1) contenu dans un groupe de panneaux contenu dans la paire à une ligne d'assemblage de composant identifiée par des informations de la ligne d'assemblage de composant correspondant à l'autre type de panneau (g2) contenu dans l'autre groupe de panneaux contenu dans la paire,
la quantité de travail est le temps de travail requis pour modifier une configuration de ligne d'assemblage de composant,
le temps de travail de la modification est calculé selon au moins un parmi, ou une combinaison arbitraire du nombre de dispositifs d'assemblage de composant contenus dans une ligne d'assemblage de composant, le type d'une tête d'assemblage fixée au dispositif d'assemblage de composant (130) et le nombre de ceux-ci, et le type de dispositif d'alimentation de composant utilisé dans le dispositif d'assemblage de composant (130) et le nombre de ceux-ci ainsi que les temps d'assemblage / de démontage des dispositifs d'assemblage de composant, les têtes d'assemblage et les types de dispositif d'alimentation,
la section de commande (118) est en outre configurée pour
initialiser un ensemble de groupes de panneaux (G) avec tous les groupes de panneaux,
sélectionner un groupe de panneaux comprenant des panneaux produits dans une configuration de ligne actuelle, comme un groupe de panneaux à produire en premier,
répéter tant que l'ensemble de groupes de panneaux (G) n'est pas vide
supprimer le dernier groupe de panneaux (g) sélectionné de l'ensemble de groupes de panneaux (G),
sélectionner, parmi l'ensemble de groupes de panneaux (G), un groupe de panneaux dont la quantité de travail de modification du dernier groupe de panneaux (g) sélectionné représente le minimum, comme un groupe de panneaux à produire ensuite, et
ainsi identifier un ordre d'entrée dans la ligne d'assemblage de composant du type de panneau de sorte qu'une valeur totale de la quantité de travail devient minimale.

2. Dispositif de design de ligne d'assemblage de composant (110) selon la revendication 1, dans lequel la section de commande (118), quand les lignes d'assemblage de composant identifiées par les informations de la ligne d'assemblage de composant correspondant aux types de panneau respectifs sont égales ou quand les nombres des dispositifs d'assemblage de composant (130: 130A, 130B) contenus dans les lignes d'assemblage de composant identifiées par les informations de la ligne d'assemblage correspondant aux types de panneau respectifs sont égales et que des configurations des lignes d'assemblage de composant présentent une relation inclusive entre les types de panneau respectifs, génère un groupe de panneaux qui comprend les types de panneau.

3. Dispositif de design de ligne d'assemblage de composant (110) selon l'une quelconque des revendications 1 ou 2, dans lequel la section de commande (118) utilise, comme un type de panneau contenu dans un groupe de panneaux contenu dans la paire et l'autre type de panneau contenu dans l'autre groupe de panneaux contenu dans la paire, un type de panneau ayant le plus grand nombre de têtes d'assemblage (145A, 145B) et les dispositifs d'alimentation de composants (140, 151, 153) contenus dans une ligne d'assemblage de composant identifiée par les informations de la ligne d'assemblage de composant correspondant à un type de panneau contenu dans le groupe de panneaux pertinent.

4. Dispositif de design de ligne d'assemblage de composant (110) selon l'une quelconque des revendications 1 à 3, dans lequel
si une différence entre un nombre des dispositifs d'assemblage de composant (130: 130A, 130B) contenus dans une ligne d'assemblage de composant identifiée par des informations de la ligne d'assemblage de composant correspondant à un type de panneau (g1) et un nombre de dispositifs d'assemblage de composant (130 : 130A, 130B) contenus dans une ligne d'assemblage de composant identifiée par des informations de la ligne d'assemblage de composant correspondant à l'autre type de panneau (g2) est positive, la section de commande (118) est conçue pour calculer le nombre de démontages du dispositif multiplié par le temps de démontage du dispositif et ajouter ce temps au temps de travail, et
si une différence entre un nombre des dispositifs d'assemblage de composant (130 : 130A, 130B) contenus dans une ligne d'assemblage de composant identifiée par des informations de la ligne d'assemblage de composant correspondant à l'autre groupe de panneaux (g2) et un nombre de dispositifs d'assemblage de composant (130 : 130A, 130B) contenus dans une ligne d'assemblage de composant identifiée par les informations de la ligne d'assemblage de composant correspondant à un groupe de panneaux (g1) est positive, la section de commande (118) est conçue pour calculer le temps d'assemblage multiplié par le nombre d'assemblages du dispositif et ajouter ce temps au temps de travail.

5. Dispositif de design de ligne d'assemblage de composant (110) selon l'une quelconque des revendications 1 à 4, dans lequel
un nombre de démontages de têtes d'assemblage (145A, 145B) dans la commutation d'un groupe de panneaux (g1) à l'autre groupe de panneaux (g2) est déterminé, alors la section de commande (118) est conçue pour calculer le temps de démontage de têtes multiplié par le nombre de démontages de têtes d'assemblage (145A, 145B) et ajouter ce temps au temps de travail, et
un nombre d'assemblages de têtes d'assemblage (145A, 145B) dans la commutation d'un groupe de panneaux (g1) à l'autre groupe de panneaux (g2) est déterminé, alors la section de commande (118) est conçue pour calculer le temps d'assemblage des têtes multiplié par le nombre d'assemblages de têtes et ajouter ce temps au temps de travail.

6. Dispositif de design de ligne d'assemblage de composant (110) selon l'une quelconque des revendications 1 à 5, dans lequel
un nombre de types de démontage de dispositifs d'alimentation de composant (140, 151, 153) dans la commutation d'un groupe de panneaux (g1) à l'autre groupe de panneaux (g2) est déterminé, alors la section de commande (118) est conçue pour calculer le temps de démontage des types de dispositifs d'alimentation multiplié par le nombre de types de démontage de dispositifs d'alimentation de composant (140, 151, 153) et ajouter ce temps au temps de travail, et
un nombre de types d'assemblage de dispositifs d'alimentation de composant (140, 151, 153) dans la commutation d'un groupe de panneaux (g1) à l'autre groupe de panneaux (g2) est déterminé, alors la section de commande (118) est conçue pour calculer le temps d'assemblage des types de dispositifs d'alimentation multiplié par le nombre de types d'assemblage de dispositifs d'alimentation de composant (140, 151, 153) et ajouter ce temps au temps de travail.

7. Système d'assemblage de composant, comprenant : un dispositif de design de ligne d'assemblage de composant (110) selon l'une quelconque des revendications 1 à 6 ; et un dispositif d'assemblage de composant (130 : 130A, 130B) qui produit un panneau correspondant à un type de panneau pertinent dans une séquence d'entrée de type de panneau défini par le dispositif de design de ligne d'assemblage de composant (110).

8. Programme amenant un ordinateur (900) à fonctionner comme une unité de stockage (111) conçue pour stocker des informations de la ligne d'assemblage de composant pour identifier, pour chaque type de panneau, un ordre d'agencement des dispositifs d'assemblage de composant (130 : 130A, 130B) dans la production du type de panneau, une position où une tête d'assemblage (145A, 145B) est fixée au dispositif d'assemblage de composant (130 : 130A, 130B), un type de la tête d'assemblage (145A, 145B) assemblée à la position, et un type de dispositif d'alimentation de composant (140, 151, 153) du dispositif d'assemblage de composant (130 : 130A, 130B), et une unité de commande,
dans lequel
le programme amène l'unité de commande (118) à
préparer les groupes de panneaux de types de panneau, et
à calculer, pour chaque paire des groupes de panneaux des types de panneau, une quantité de travail pour la modification d'une ligne d'assemblage de composant identifiée par des informations de la ligne d'assemblage de composant correspondant à un type de panneau contenu dans un groupe de panneaux (g1) contenu dans la paire à une ligne d'assemblage de composant identifiée par des informations de la ligne d'assemblage de composant correspondant à l'autre type de panneau contenu dans l'autre groupe de panneaux (g2) contenu dans la paire,
la quantité de travail est le temps de travail requis pour modifier une configuration de ligne d'assemblage de composant,
le temps de travail de la modification est calculé selon au moins un parmi, ou une combinaison arbitraire du nombre de dispositifs d'assemblage de composant contenus dans une ligne d'assemblage de composant, le type d'une tête d'assemblage fixée au dispositif d'assemblage de composant (130) et le nombre de ceux-ci, et le type de dispositif d'alimentation de composant utilisé dans le dispositif d'assemblage de composant (130) et le nombre de ceux-ci ainsi que les temps d'assemblage / de démontage des dispositifs d'assemblage de composant, les têtes d'assemblage et les types de dispositifs d'alimentation,
le programme amène en outre l'unité de commande (118) à
initialiser un ensemble de groupes de panneaux (G) avec tous les groupes de panneaux,
sélectionner un groupe de panneaux comprenant des panneaux produits dans une configuration de ligne actuelle, comme un groupe de panneaux à produire en premier,
répéter tant que l'ensemble de groupes de panneaux (G) n'est pas vide
supprimer le dernier groupe de panneaux (g) sélectionné de l'ensemble de groupes de panneaux (G),
sélectionner, parmi l'ensemble de groupes de panneaux (G), un groupe de panneaux dont la quantité de travail de modification du dernier groupe de panneaux (g) sélectionné est le minimum, comme un groupe de panneaux à produire ensuite, et ainsi identifier un ordre d'entrée dans la ligne d'assemblage de composant du type de panneau de sorte qu'une valeur totale de la quantité de travail devient minimale.

9. Programme selon la revendication 8, dans lequel
l'unité de commande (118), quand les lignes d'assemblage de composant identifiées par les informations de la ligne d'assemblage de composant correspondant aux types de panneau respectifs sont égales ou quand les nombres des dispositifs d'assemblage de composant (130 : 130A, 130B) contenus dans des lignes d'assemblage de composant identifiées par les informations de la ligne d'assemblage correspondant aux types de panneau respectifs sont égales et que des configurations des lignes d'assemblage de composant présentent une relation inclusive entre les types de panneau respectifs, génère un groupe de panneaux qui comprend les types de panneau.

10. Programme selon l'une quelconque des revendications 8 ou 9, dans lequel comme un type de panneau contenu dans un groupe de panneaux contenu dans la paire et l'autre type de panneau contenu dans l'autre groupe contenu dans la paire, l'unité de commande (118) utilise un type de panneau ayant le plus grand nombre de têtes d'assemblage (145A, 145B) et de dispositifs d'alimentation de composants (140, 151, 153) contenus dans une ligne d'assemblage de composant identifiée par les informations de la ligne d'assemblage de composant correspondant à un type de panneau contenu dans le groupe de panneaux pertinent.

11. Programme selon l'une quelconque des revendications 8 à 10, dans lequel si une différence entre un nombre des dispositifs d'assemblage de composant (130 : 130A, 130B) contenus dans une ligne d'assemblage de composant identifiée par des informations de la ligne d'assemblage de composant correspondant à un type de panneau (g1) et un nombre de dispositifs d'assemblage de composant (130 : 130A, 130B) contenus dans une ligne d'assemblage de composant identifiée par les informations de la ligne d'assemblage de composant correspondant à l'autre type de panneau (g2) est positive, l'unité de commande (118) est conçue pour calculer le nombre de démontages des dispositifs multiplié par le temps de démontage des dispositifs et ajouter ce temps au temps de travail, et
si une différence entre un nombre des dispositifs d'assemblage de composant (130 : 130A, 130B) contenus dans une ligne d'assemblage de composant identifiée par des informations de la ligne d'assemblage de composant correspondant à l'autre groupe de panneaux (g2) et un nombre de dispositifs d'assemblage de composant (130 : 130A, 130B) contenus dans une ligne d'assemblage de composant identifiée par les informations de la ligne d'assemblage de composant correspondant à un groupe de panneaux (g1) est positive, l'unité de commande (118) est conçue pour calculer le temps d'assemblage des dispositifs multiplié par le nombre d'assemblages des dispositifs et ajouter ce temps au temps de travail.

12. Programme selon l'une quelconque des revendications 8 à 11, dans lequel
un nombre de démontages de têtes d'assemblage (145A, 145B) dans la commutation d'un groupe de panneaux (g1) à l'autre groupe de panneaux (g2) est déterminé, alors l'unité de commande (118) est conçue pour calculer le temps de démontage des têtes multiplié par le nombre de démontages des têtes d'assemblage (145A, 145B) et ajouter ce temps au temps de travail, et
un nombre d'assemblage de têtes d'assemblage (145A, 145B) dans la commutation d'un groupe de panneaux (g1) à l'autre groupe de panneaux (g2) est déterminé, alors l'unité de commande (118) est conçue pour calculer le temps d'assemblage des têtes multiplié par le nombre d'assemblages des têtes et ajouter ce temps au temps de travail.

13. Programme selon l'une quelconque des revendications 8 à 12, dans lequel
un nombre de types de démontage de dispositifs d'alimentation de composant (140, 151, 153) dans la commutation d'un groupe de panneaux (g1) à l'autre groupe de panneaux (g2) est déterminé, alors l'unité de commande (118) est conçue pour calculer le temps de démontage des types de dispositifs d'alimentation multiplié par le nombre de types de démontages de dispositifs d'alimentation de composant (140, 151, 153) et ajouter ce temps au temps de travail, et
un nombre de types d'assemblage de dispositifs d'alimentation de composant (140, 151, 153) dans la commutation d'un groupe de panneaux (g1) à l'autre groupe de panneaux (g2) est déterminé, alors l'unité de commande (118) est conçue pour calculer le temps d'assemblage des types de dispositifs d'alimentation multiplié par le nombre de types d'assemblage de dispositifs d'alimentation de composant (140, 151, 153) et ajouter ce temps au temps de travail.
